# DEMANDE DE BREVET EUROPEEN

(11) **EP 4 773 760 A1**
(43) Date de publication de la demande: **08.07.2026**
(21) Numéro de dépôt: 26150103.5
(22) Date de dépôt: 02.01.2026
(51) Int. Cl.: H10F 39/18, H10F 39/12, H10F 39/00

(54) **PROCÉDÉ ET DISPOSITIF DE ROUTAGE OPTIQUE EN POLARISATION ET/OU EN LONGUEUR D ONDE DE LA LUMIÈRE,ET DÉTECTEUR OPTOÉLECTRONIQUE L' INCORPORANT**

(30) Priorité: 03.01.2025 FR 2500039
(71) Demandeur: Commissariat à l'Energie Atomique et aux Energies Alternatives, 75015 Paris (FR)
(72) Inventeur: CHATAIGNIER, Guillaume, 38054 Grenoble cedex 09 (FR)
(74) Mandataire: INNOV-GROUP

(57) **Abrégé**

Un détecteur optoélectronique (40") comprend un dispositif (42") de routage optique, au niveau pixel, en polarisation ou en longueur d'onde de la lumière incidente (10), qui est formé au-dessus d'une matrice de photodétecteurs (41"). Un agencement (30x') des routeurs optiques élémentaires permet de réduire les inconvénients du couplage optique réciproque entre pixels adjacents tout en bénéficiant de la meilleure sensibilité du détecteur optoélectronique offerte par le routage optique par rapport au filtrage optique. A cette fin, les motifs de routage de deux routeurs élémentaires adjacents suivant la direction (X) de routage de la lumière, sont disposés en miroir l'un de l'autre suivant cette direction. Ainsi, un pixel associé à l'un des routeurs élémentaires et un pixel associé à l'autre des routeurs élémentaires, qui sont dédiés à la détection du même état de polarisation ou de la une même longueur d'onde, sont contigus suivant la direction de routage de la lumière.

## Description

### Domaine technique de l'invention

La présente invention se rapporte de manière générale à l'imagerie polarimétrique ("*Polarization imaging*" en anglais) et/ou colorimétrique, et concerne plus particulièrement un procédé et un dispositif de routage en polarisation et/ou en longueur d'onde de la lumière (c'est-à-dire un routage basé sur, ou dépendant de la polarisation et/ou de la longueur d'onde), ainsi qu'à un détecteur optoélectronique, par exemple un capteur d'image CMOS, incorporant ledit dispositif.

L'invention trouve des applications, par exemple, dans les systèmes de vision pour la robotique industrielle ou dans les systèmes mobiles autonomes tels que, de manière non limitative, les véhicules, les robots ou les drones.

### Arrière-plan technologique

Des systèmes du type précité utilisent une caméra de vision polarisée pour améliorer la qualité des images grâce à la suppression de reflets, ou pour permettre la détection et/ou l'identification de certains matériaux présentant un effet polarisant, ou encore pour permettre une assistance pour la reconstruction de la profondeur (dite "estimation de z").

Le principe de l'imagerie polarimétrique consiste à capter séparément plusieurs états de polarisation de la lumière pour une même scène optique donnée. La connaissance individuelle des différents états de polarisation de la lumière, en général *a minima* deux polarisations linéaires orthogonales entre elles, permet d'extraire des informations d'intérêt en rapport avec la scène. Par exemple, des caméras de vision à polarisations actuellement utilisées dans l'industrie permettent d'inspecter des surfaces réfléchissantes telles que le verre ou le métal, ce qui s'avère difficile avec les caméras monochromes ou les caméras couleurs conçues pour une vision conventionnelle. Idéalement, un capteur optoélectronique dédié à la vision à polarisations doit permettre d'acquérir des images de la même scène optique pour différents états de polarisation de la lumière, simultanément et avec le même point de vue (absence de tout parallaxe, d'origine temporelle ou spatiale) afin que les images captées soient strictement superposables.

Les intégrateurs de vision connus dans l'industrie s'utilisent souvent en association avec un dispositif optique principal formant un filtre de polarisation, monté sur l'objectif de la caméra. Néanmoins, par conception, ce filtre ne peut bloquer que la lumière polarisée que suivant un angle déterminé, qui est unique car il est défini par les caractéristiques du filtre tel qu'il est concrètement réalisé.

Dans l'état de la technique, on connaît aussi les capteurs d'image CMOS à obturateur global IMX250MZR^{™}, IMX264MZR^{™} et IMX253MZR^{™} de la famille Sony Pregius^{™}, de la société SONY Inc.. Ce sont des dispositifs optoélectroniques intégrés qui utilisent des filtres monochromes quadruplement polarisés pour capturer la lumière polarisée selon quatre plans. Ces capteurs peuvent ainsi capturer simultanément des images de la même scène dans quatre directions lumineuses différentes, correspondant à quatre angles d'observation respectifs. Cette solution fonctionne par filtrage de la lumière. Le capteur d'image est en effet équipé d'un filtre polarisant qui est un polariseur quadri-directionnel placé sur les photodiodes du capteur CMOS, ou pixels. Ce polariseur permet au capteur de capturer une image quadri-directionnelle en une seule prise de vue. Une électronique d'exploitation calcule alors l'angle et la direction de la polarisation concernée en fonction de l'intensité lumineuse globalement captée pour chacune des directions de polarisation. Le filtre incorpore un motif de pixels de format 2x2, où chacun des pixels d'un pavé carré de quatre pixels adjacents deux-à-deux est associé à un filtre élémentaire avec un angle d'observation respectif parmi les quatre directions de polarisation prises en compte. Lors de l'utilisation sous une lumière polarisée, seule la partie de la lumière perpendiculaire à l'angle d'observation du filtre associé à un pixel donné passe vers ledit pixel, le reste du flux lumineux étant bloqué par l'effet du filtrage optique.

Ainsi, les caractéristiques du filtre de polarisation sont les suivantes :
- lorsque le filtre bloque la lumière polarisée à un angle de 90°, il laisse passer la lumière polarisée à un angle de 0° ;
- lorsqu'il bloque la lumière à un angle de 45°, il laisse passer la lumière polarisée à un angle de 135° ;
- lorsqu'il bloque la lumière à un angle de 135°, il laisse passer la lumière polarisée à un angle de 45° ; et/ou, enfin,
- lorsqu'il bloque la lumière à un angle de 0°, il laisse passer la lumière polarisée à un angle de 90°.

On parle aussi d'extinction pour désigner le blocage de la partie du flux lumineux qui ne passe pas à travers le filtre, et n'atteint donc pas la surface sensible du capteur d'image CMOS.

Les capteurs de caméra à polarisations IMX250MZR^{™}, IMX264MZR^{™} et IMX253MZR^{™} précités comprennent donc un filtre polariseur, lequel est positionné sous la couche de lentilles intégrée à la puce. Ceci permet d'améliorer l'angle d'incidence et le rapport d'extinction par rapport à une disposition classique du polariseur au-dessus des lentilles, en raison de la distance plus courte entre le polariseur et les photodiodes de détection. Mais ces capteurs utilisent le principe du filtrage de polarisation. Ils sont à base de filtres métalliques. De ce fait, les capteurs offrent un fort taux de rejection en polarisation. Mais l'efficacité quantique est très dégradée, en ce sens qu'une partie très limitée du flux optique incident atteint les photodiodes. Ces capteurs présentent donc une faible sensibilité.

L'intérêt du routage optique en polarisation de la lumière, par rapport au filtrage de polarisation des capteurs discutés ci-dessus, est de récupérer plus de flux lumineux et donc d'augmenter la sensibilité du capteur.

L'invention se place dans le contexte des détecteurs optoélectroniques dans lesquels la séparation des états de polarisation de la lumière a lieu directement au niveau de la surface sensible du capteur photoélectrique, à l'échelle du photodétecteur élémentaire ou pixel. L'idée est de recouvrir plusieurs pixels, et plus précisément deux pixels au moins qui sont adjacents suivant une direction déterminée, dite direction de routage, par un élément optique unitaire dont le rôle est de router la lumière en fonction de son état de polarisation : la lumière ayant un état de polarisation A est déviée sélectivement pour converger dans le pixel de type A associé, la lumière ayant un état de polarisation B est déviée sélectivement pour converger dans un autre pixel de type B associé, etc... L'élément optique unitaire qui est associé aux pixels de types A, B, etc. pour assurer ce routage optique basé sur la polarisation de la lumière, dit routeur unitaire, présente un motif rectangulaire ou carré de format N×M, où N et M sont des nombres entiers déterminés, qui est répétés sur toute la surface du détecteur optoélectronique. La structure de polarisation formée par la répétition spatiale, en 2D, du motif de ce routeur unitaire afin de couvrir la surface du capteur, forme un dispositif de routage de la lumière en fonction de son état de polarisation, dit routeur optique en polarisation.

On ne connaît aucun produit optoélectronique qui soit diffusé commercialement, qui utilise de tels routeurs optiques en polarisation. Cependant, certains articles de recherche scientifique récents abordent le sujet et proposent des approches expérimentales basées sur l'utilisation de méta-surfaces.

L'article intitulé "Metasurface-based polarization color routers", par Xiujuan Zou, Guangxing Gong, Yu Lin, Boyan Fu, Shuming Wang, Shining Zhu, et Zhenlin Wang, dans la revue Optics and Lasers in Engineering, Volume 163, Avril 2023, 107472, ISSN 0143-8166 (https://doi.org/10.1016/j.optlaseng.2022.107472) divulgue ainsi un routeur de couleurs de polarisation basé sur une méta-surface, qui peut capturer simultanément un motif de Bayer (distribution R-G-G-B) sous une lumière blanche avec n'importe quelle polarisation pour l'imagerie couleur et la détection de la polarisation. Contrairement à une conception prospective de méta-surface, la méta-surface discutée dans cet article est conçue à l'inverse en utilisant un algorithme d'optimisation globale (c'est-à-dire un algorithme générique) en fonction des objectifs de routage optique de toute la lumière incidente vers les différents ports de sortie. On utilise la symétrie de distribution des nanostructures pour réaliser la réponse en polarisation, ce qui simplifie considérablement la complexité de la conception de la structure de polarisation. Chaque cellule élémentaire de la méta-surface remplit les deux fonctions de focalisation et de routage de la lumière dans le spectre optique considéré. Ceci pallie les problèmes connus qui sont liés au faible taux de pénétration de la lumière de la plupart des capteurs d'image couleur conventionnels.

L'article intitulé "Efficient polarization beam splitter pixels based on a dielectric metasurface" par M. Khorasaninejad, W. Zhu, et K. B. Crozier, Optica Vol.2, Issue 4, pp. 376-382, 2015 (https://doi.org/10.1364/OPTICA.2.000376), divulgue un concept de nouvelle méthode pour la polarimétrie au niveau du pixel. Chaque pixel contient des nanoparticules de silicium amorphe et dévie la lumière incidente en fonction de la polarisation. Comme les photons sont répartis en fonction de la polarisation plutôt que filtrés, l'approche permet d'atteindre une grande efficacité, *i.e.,* une grande sensibilité du capteur.

L'article intitulé "Efficient polarization beam splitter pixels based on a dielectric metasurface", par Shuwen Wei, Zhenyu Yang, et Ming Zhao, Optics Letters 2017, Vol. 42, Issue 8, pp. 1580-1583, (https://doi.org/10.1364/OL.42.001580) divulgue quant à lui un polariseur ultracompact basé sur des méta-surfaces diélectriques. L'élément optique élémentaire de la méta-surface proposée dans l'article comporte quatre zones agencées suivant un motif déterminé. Chaque zone agit non seulement comme un séparateur de polarisation, mais aussi comme une lentille de focalisation plate. Ainsi, elle peut acquérir une certaine composante de polarisation de la lumière incidente et la focaliser sur le récepteur associé. Par conséquent, les paramètres de *Stokes* de la lumière incidente peuvent être immédiatement déterminés, grâce aux données du récepteur.

Cependant, les solutions à base de routeurs ainsi connues soulèvent la problématique du couplage réciproque, aussi appelé couplage croisé ("*Crosstalk*" en anglais), entre les différents états de polarisation de la lumière. En effet, les pixels sensibles à des polarisations différentes sont jointifs (*i.e.,* contigus) en surface du détecteur optique, si bien que les imperfections inhérentes du routage ont pour résultat la réception par un pixel voisin d'une partie de la lumière qui est sensée être routée vers chaque pixel donné. Ce problème existe déjà en cas d'illumination sous incidence normale (*i.e.,* orthogonale à la surface sensible du détecteur optique), et il est encore exacerbé lorsqu'on considère un angle d'incidence de la lumière différent, défini par l'ouverture de l'optique principale éventuellement placée devant le détecteur optique.

Les filtres de polarisation, c'est-à-dire les dispositifs basés sur le filtrage optique en fonction de la polarisation de la lumière tels que ceux présentés en premier lieu dans ce qui précède (en référence notamment aux capteurs précités de la société Sony Inc.), sont beaucoup moins touchés par ce problème de couplage réciproque. En effet, chaque élément optique filtrant ne doit pas faire passer la lumière ailleurs que dans le pixel qui est placé juste en-dessous, orthogonalement. L'art antérieur relatif à ce type de dispositifs est donc peu pertinent à l'égard du problème posé, lié couplage croisé entre pixels adjacents.

Des travaux existent par ailleurs pour un placement idéal de filtres colorés (typiquement Rouge, Vert et Bleu) sur un capteur CMOS en imagerie couleur classique. En général, ces travaux ne prennent pas en considération, à proprement parler, le couplage réciproque entre pixels dédiés à des couleurs respectives, mais visent des fonctions avancées comme une meilleure reconstruction de chaque couleur, une meilleure résolution spatiale, un dé-matriçage facilité des signaux électriques générés, etc... On peut citer par exemple les capteurs "quad-Bayer" de SAMSUNG et SONY, et le motif Xtrans^{™} de la société FUJIFILM (divulgué dans le document WO2023275032A1).

Le document EP4390343 A1 divulgue un capteur d'images polarimétrique formé dans et sur un substrat semiconducteur, le capteur comprenant une pluralité de pixels comprenant chacun un photodétecteur formé dans le substrat semiconducteur, ainsi en outre qu'un filtre polariseur disposé du côté d'une face d'éclairement des photodétecteurs et comprenant, pour chaque pixel, une structure de polarisation, ainsi enfin qu'un routeur de polarisation comprenant une méta-surface bidimensionnelle disposée du côté du filtre polariseur opposé aux photodétecteurs, la méta-surface comprenant un réseau bidimensionnel de plots. Dans ce document, il est considéré une décomposition de motifs élémentaires de routage de la lumière en éléments plus petits qu'eux, à savoir les zones de sortie optique de chaque motif élémentaire. Cette décomposition se base sur des axes de symétrie intrinsèques de l'arrangement des plots de la méta-surface correspondante qui sont des piliers nano structurés.

### Résumé de l'invention

L'invention vise à réduire les problèmes de couplage réciproque dans une matrice à deux dimensions (2D) de photodétecteurs (ou pixels) associée à un routeur optique en polarisation et/ou en longueur d'onde, pour la détection d'une lumière polarisée et/ou polychromatique, respectivement, afin d'améliorer la sensibilité du détecteur optoélectronique incorporant cette matrice de pixels.

L'idée à la base de l'invention consiste à spécifier la disposition relative de routeurs de base qui sont répétés spatialement pour couvrir la surface sensible du détecteur optoélectronique, afin de diminuer l'effet du couplage réciproque ("*Crosstalk*") au sein de la matrice de photodétecteurs et ainsi améliorer l'efficacité du routage. Cette efficacité peut être reflétée par le taux d'extinction (ou PER, mis pour "*Polarization Extinction Ratio*" en anglais). Cette idée peut s'exploiter dans le contexte du routage optique en polarisation de la lumière, mais pas uniquement. Elle peut en effet être également exploitée dans le contexte du routage optique en longueur d'onde de la lumière. En particulier, on dispose des routeurs élémentaires en miroir pour placer côte-à-côte (c'est-à-dire de manière adjacente et contigüe) les pixels de deux motifs adjacents qui sont dédiés à la détection de la lumière ayant un état de polarisation donné ou une longueur d'onde donnée. Cette idée est propre à la technique de routage optique, par exemple en polarisation et/ou en longueur d'onde de la lumière. Il n'existe pas de travaux connus sur un agencement idéal de routeurs optiques en polarisation ou de routeurs optiques en longueur d'onde, en surface d'un détecteur optoélectronique tel qu'un capteur CMOS.

Un premier aspect de l'invention se rapporte à un détecteur optoélectronique comprenant :
une matrice de photodétecteurs élémentaires ou pixels agencés en lignes s'étendant suivant une première direction et en colonnes s'étendant suivant une seconde direction, différente de ladite première direction, lesdites première direction et seconde direction définissant le plan d'une surface du détecteur optoélectronique qui est sensible à une lumière incidente,
   - un dispositif de routage optique, au niveau pixel, en polarisation ou en longueur d'onde de la lumière incidente, qui est formé au-dessus de la matrice de photodétecteurs,
dans lequel:
   - le dispositif de routage optique de la lumière comprend un ou plusieurs routeurs de base présentant chacun un motif de routage de base identique,
      o le ou les routeurs de base étant disposés au-dessus de la matrice de photodétecteurs, le cas échéant de telle manière que le motif de routage de base est répété spatialement suivant la première direction et/ou suivant la seconde direction pour couvrir tout ou partie de ladite matrice, et
      ∘ le motif de routage de base étant symétrique selon la première direction et/ou selon la seconde direction,

   - chaque routeur de base comprend au moins deux routeurs élémentaires ayant chacun une zone d'entrée optique et plusieurs zones de sortie optique,
      ∘ les routeurs élémentaires étant adjacents deux-à-deux suivant la première direction et/ou suivant la seconde direction, et
      ∘ les routeurs élémentaires présentant chacun un motif de routage élémentaire identique de format N×M, où N et M sont des nombres entiers supérieurs à l'unité dont l'un au moins est strictement supérieur à l'unité, lesdits nombres N et M désignant le nombre de zones de sortie optique du routeur élémentaire qui sont adjacentes deux-à-deux, le cas échéant, suivant la première direction et suivant la seconde direction, respectivement,
   - chaque routeur élémentaire est adapté pour trier en sortie par routage optique, c'est-à-dire par déviation sélective vers l'une des zones de sortie optique dudit routeur élémentaire, la lumière reçue au niveau de la zone d'entrée optique dudit routeur élémentaire en fonction de sa polarisation ou de sa longueur d'onde, les zones de sortie optique dudit routeur élémentaire étant couplées de manière opérationnelle chacune à un pixel associé respectif de la matrice de photodétecteurs sous-jacente qui est dédié (par exemple seul, ou bien en combinaison avec d'autres pixels similaires) à la détection d'un flux de lumière incidente avec une polarisation déterminée ou à une longueur d'onde déterminée,
   - au moins deux routeurs élémentaires qui sont adjacents suivant la première direction ou suivant la seconde direction au sein d'un routeur de base sont agencés de telle manière que leurs motifs de routage élémentaires respectifs sont disposés en miroir l'un de l'autre suivant ladite direction, de sorte qu'un ou plusieurs pixels associés à des zones de sortie de l'un desdits routeurs élémentaires et un ou plusieurs pixels associés à des zones de sortie de l'autre desdits routeurs élémentaires, qui sont dédiés à la détection du flux de lumière incidente avec un même état de polarisation ou à une même longueur d'onde, soient contigus suivant ladite direction.

Ainsi, même en cas de couplage réciproque entre des pixels au sein de la matrice de photodétecteurs, une partie de la lumière ayant une polarisation déterminée ou une longueur d'onde déterminée (selon le type de routeur optique) et qui est déviée au-delà du pixel dédié à la détection de cette caractéristique optique de la lumière incidente, tombera quand même dans un pixel adjacent qui est également dédié à cette détection. Le PER sera moins dégradé, tout en bénéficiant de la meilleure sensibilité du détecteur qu'offre le routage optique par rapport au filtrage optique. Ce résultat est atteint pour des pixels associés à des zones de sortie optique au sein du motif de base qui sont formées côte-à-côte, compte tenu de la mise en miroir d'au moins deux motifs élémentaires qui le composent. Mais cet effet est également obtenu, en outre, pour des pixels associés à des zones de sortie optique en périphérie de deux routeurs de base adjacents lorsque des routeurs de base spatialement répétés dans le dispositif de routage optique sont formés côte-à-côte et sans espacement (c'est-à-dire qu'ils sont répétés de façon contigüe deux-à-deux), suivant la première direction ou suivant la seconde direction, du fait de la symétrie du motif de base suivant l'une et/ou l'autre de ces directions.

Cet agencement des routeurs optiques élémentaires en polarisation ou longueur d'onde de la lumière, apporte une solution au problème technique de couplage croisé entre pixels adjacents qui est propre à la fonction de routage de la lumière dévolue aux routeurs élémentaires ainsi alignés le long de la direction de routage. On entend par là qu'un agencement identique ou comparable, *i.e.,* avec une mise en miroir (« *mirroring* » en anglais) d'éléments optiques adjacents, peut éventuellement avoir déjà été envisagé (ou pourrait l'être) pour d'autres raisons et/ou dans d'autres applications ; mais que, dans le contexte spécifique de l'application à des routeurs optiques en polarisation ou en longueur d'onde de la lumière suivant une direction de routage qui correspond à la direction d'alignement des routeurs élémentaires, cette mise en miroir produit un effet technique qui est propre à la solution au problème technique consistant à réduire les inconvénients du couplage optique réciproque entre pixels adjacents tout en bénéficiant de la meilleure sensibilité du détecteur optoélectronique offerte par le routage optique par rapport au filtrage optique, comme exposé en introduction.

Dans un mode de réalisation, le dispositif de routage optique de la lumière peut être un dispositif de routage optique en polarisation de la lumière, dans lequel :
- un routeur élémentaire comprend un ou plusieurs routeurs binaires ayant chacun deux zones de sortie optique respectives (parmi les zones de sortie optique dudit routeur élémentaire, dans l'exemple),
   ∘ les deux zones de sortie optique du routeur binaire étant adjacentes suivant la première direction ou suivant la seconde direction, et
   ∘ le routeur binaire présentant un motif de routage binaire de format 2×1 ou 1×2, respectivement,
- chaque routeur binaire est adapté pour trier en sortie par routage optique, c'est-à-dire par déviation optique sélective vers l'une des deux zones de sortie optique dudit routeur binaire, la lumière incidente reçue au niveau de la zone d'entrée optique du routeur élémentaire en fonction de sa polarisation parmi deux états de polarisation croisés respectifs.

Dans un mode de réalisation:
- un routeur binaire au moins du routeur élémentaire peut être adapté pour trier en sortie par routage optique la lumière incidente reçue au niveau de la zone d'entrée optique dudit routeur élémentaire en fonction de la polarisation de ladite lumière parmi des paires d'états de polarisation linéaire orthogonaux entre eux, par exemple les polarisations linéaires à 0° et à 90°, respectivement, ou les polarisations linéaires à 45° et à 135°, respectivement.

Dans un mode de réalisation :
- le motif de routage élémentaire d'un routeur élémentaire déterminé peut être un motif de routage de format 2×2 à quatre zones de sortie optique,
   o ledit routeur élémentaire comprenant deux routeurs binaires (par exemple des routeurs binaires à motif de routage élémentaire, à deux zones de sortie optique chacun, de format 2×1 ou de format 1×2, dans l'exemple),
   o lesdits routeurs binaires étant adaptés chacun pour trier en sortie par routage optique la lumière incidente reçue au niveau de la zone d'entrée optique du routeur élémentaire en fonction de la polarisation de ladite lumière parmi des paires respectives d'états de polarisation linéaire orthogonaux entre eux, à savoir par exemple les polarisations linéaires à 0° et à 90° pour l'un desdits routeurs binaires, et les polarisations linéaires à 45° et à 135° pour l'autre desdits routeurs binaires.

Dans un mode de réalisation :
- le motif de routage de base du routeur de base peut être un motif de routage de format 4×2 comprenant huit zones de sortie optique,
   ∘ ledit routeur de base comprenant deux routeurs élémentaires à motif de routage élémentaire de format 2×2 comprenant chacun deux routeurs binaires à motif de routage binaire de format 2×1 ou de format 1×2, qui sont adjacents suivant la première direction ou suivant la seconde direction, respectivement,
   ∘ lesdits routeurs élémentaires étant adjacents suivant la première direction ou suivant la seconde direction au sein du routeur de base et agencés de telle manière que leurs motifs de routage élémentaires respectifs sont disposés en miroir l'un de l'autre suivant ladite direction, de sorte qu'un ou plusieurs pixels associés à des zones de sortie de l'un desdits routeurs élémentaires et qu'un ou plusieurs pixels associés à des zones de sortie de l'autre desdits routeurs élémentaires, qui sont dédiés à la détection du flux de lumière avec un même état de polarisation linéaire, soient contigus suivant ladite direction.

Dans un mode de réalisation :
- un routeur binaire au moins d'un routeur élémentaire peut être adapté pour trier en sortie par routage optique la lumière incidente reçue au niveau de la zone d'entrée optique dudit routeur élémentaire en fonction de la polarisation de ladite lumière parmi les états de polarisation circulaire gauche et circulaire droite (i.e., parmi la polarisation circulaire gauche et la polarisation circulaire droite, dans l'exemple).

Dans un mode de réalisation :
- le motif de routage élémentaire d'un routeur élémentaire peut être un motif de routage de format 3×2 ou de format 2×3 à six zones de sortie optique,
   ∘ ledit routeur élémentaire comprenant trois routeurs binaires (par exemple des routeurs binaires à motif de routage de format 2×1 ou de format 1×2, à deux zones de sortie chacun),
   o lesdits routeurs binaires étant adaptés chacun pour trier en sortie par routage optique la lumière incidente reçue au niveau de la zone d'entrée dudit routeur binaire en fonction de la polarisation de ladite lumière parmi des paires respectives d'états de polarisation orthogonaux, à savoir les états de polarisation linéaire orthogonaux à 0° et à 90° pour un premier desdits routeurs binaires, les états de polarisation linéaire orthogonaux à 45° et à 135° pour un deuxième desdits routeurs binaires, et les états de polarisation circulaire gauche et circulaire droite pour un troisième desdits routeurs binaires.

Dans un mode de réalisation :
- le motif de routage de base d'un routeur de base peut être un motif de routage de format 4×3 ou de format 3×4 comprenant douze zones de sortie optique,
   ∘ ledit routeur unitaire comprenant deux routeurs élémentaires à motif de routage de format 2×3 ou de format 3×2 comprenant chacun trois routeurs binaires à motif de routage de format 2×1 ou de format 1×2,
   ∘ lesdits routeurs élémentaires étant adjacents suivant la première direction ou suivant la seconde direction au sein du routeur de base et agencés de telle manière que leurs motifs de routage élémentaires respectifs sont disposés en miroir l'un de l'autre suivant ladite direction, de sorte qu'un ou plusieurs pixels associés à des zones de sortie optique de l'un desdits routeurs élémentaires et qu'un ou plusieurs pixels associés à des zones de sortie optique de l'autre desdits routeurs élémentaires, qui sont dédiés à la détection du flux de lumière incident avec un même état de polarisation, soient contigus suivant ladite direction.

Dans un mode de réalisation :
- le motif de routage de base d'un routeur de base peut être un motif de routage de format 4×6 comprenant vingt-quatre zones de sortie optique,
   ∘ ledit routeur de base comprenant quatre routeurs élémentaires à motif de routage de format 2×3 ou de format 3×2 comprenant chacun trois routeurs binaires à motif de routage élémentaire de format 2×1 ou de format 1×2,
   ∘ lesdits routeurs élémentaires étant adjacents deux-à-deux suivant la première direction et suivant la seconde direction au sein du routeur de base et étant agencés de telle manière que leurs motifs de routage élémentaires respectifs sont disposés deux-à-deux en miroir les uns des autres suivant ladite première direction et suivant ladite seconde direction, de sorte qu'un ou plusieurs pixels associés à des zones de sortie optique de l'un desdits routeurs élémentaires et qu'un ou plusieurs pixels associés à des zones de sortie optique de l'autre desdits routeurs élémentaires, qui sont dédiés à la détection du flux de lumière incident avec un même état de polarisation, soient contigus suivant ladite direction.

Dans un mode de réalisation, le dispositif de routage optique de la lumière peut être un dispositif de routage en longueur d'onde de la lumière, et dans lequel :
- le motif de routage élémentaire d'un routeur élémentaire est un motif de routage comprenant au moins deux zones de sortie optique qui sont associées chacune à une longueur d'onde déterminée, par exemple une longueur d'onde parmi les longueurs d'onde correspondant aux couleurs rouge, vert et bleu, respectivement.

Dans un mode de réalisation :
- le motif de routage élémentaire d'un routeur élémentaire peut être un motif de routage de format 2×2 comprenant quatre zones de sortie optique, dont :
   ∘ une zone de sortie optique est couplée de manière opérationnelle à un pixel de la matrice de photodétecteurs sous-jacente qui est dédié à la détection de la lumière à la longueur d'onde correspondant à la couleur rouge, et
   ∘ deux autres zones de sortie optique qui sont mutuellement opposées diamétralement, et sont respectivement couplées de manière opérationnelle à deux pixels de la matrice de photodétecteurs sous-jacente qui sont dédiés à la détection de la lumière à la longueur d'onde correspondant à la couleur vert,
   ∘ l'autre zone de sortie optique encore (i.e., la quatrième et dernière zone de sortie optique dans l'exemple) est couplée de manière opérationnelle à un pixel de la matrice de photodétecteurs sous-jacente qui est dédié à la détection de la lumière à la longueur d'onde correspondant à la couleur bleu.

Dans un mode de réalisation :
- le motif de routage de base d'un routeur de base peut être un motif de routage de format 4×4 comprenant seize zones de sortie optique,
   ∘ ledit routeur de base comprenant quatre routeurs élémentaires chacun à motif de routage de format 2×2 qui sont adjacents deux-à-deux suivant la première direction et suivant la seconde direction au sein du routeur de base et agencés de telle manière que leurs motifs de routage élémentaires respectifs sont disposés deux-à-deux en miroir les uns des autres suivant ladite première direction et suivant ladite seconde direction.

Dans un mode de réalisation, le dispositif de routage optique en polarisation ou en longueur d'onde de la lumière peut être formé d'une méta-structure de routage optique adaptée pour trier en sortie des routeurs élémentaires par routage optique, c'est-à-dire pour dévier sélectivement vers l'une ou l'autre des zones de sortie optique desdits routeurs élémentaires, la lumière incidente reçue en entrée de la méta-structure en fonction de son état de polarisation ou de sa longueur d'onde.

Dans un mode de réalisation, des routeurs de base répétés dans le dispositif de routage optique peuvent être formés côte-à-côte et sans espacement, suivant la première direction ou suivant la seconde direction.

Dans un deuxième aspect, l'invention a également pour objet un capteur d'image en technologie CMOS comprenant un détecteur optoélectronique selon le premier aspect ci-dessus.

### Présentation des dessins

D'autres caractéristiques et avantages de l'invention apparaîtront encore à la lecture de la description qui va suivre. Celle-ci est purement illustrative et doit être lue en regard des dessins annexés sur lesquels :

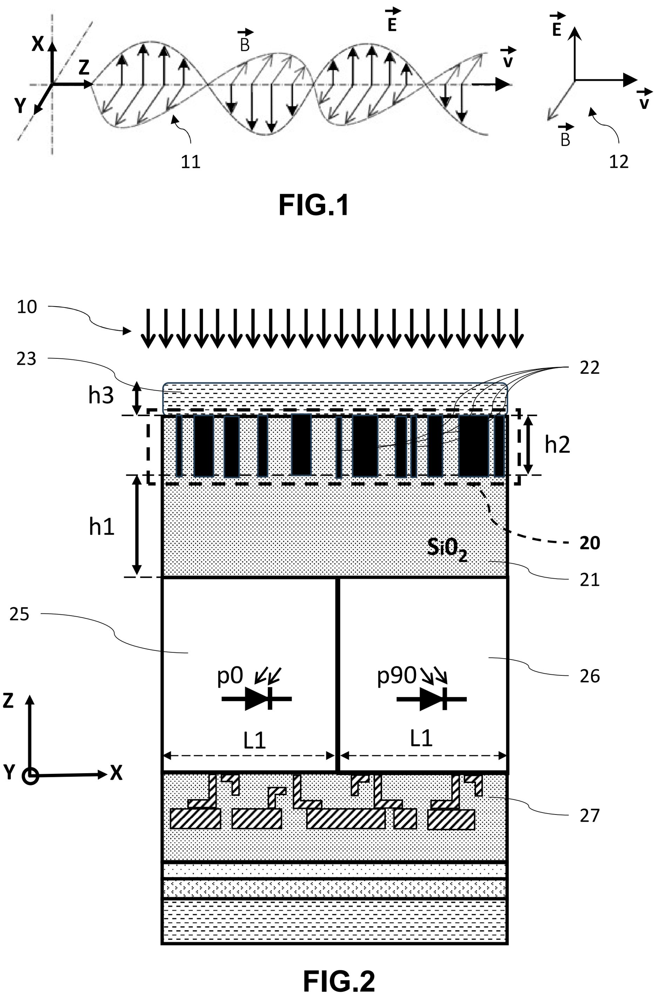

**[****FIG.1****]** est une représentation schématique d'une onde lumineuse monochromatique, suivant le modèle dit du "dipôle électrostatique vibrant".
**[****FIG.2****]** est un schéma simplifié, en coupe verticale, d'un détecteur optoélectronique comprenant une nanostructure de routage optique sélectif de type méta-surface.

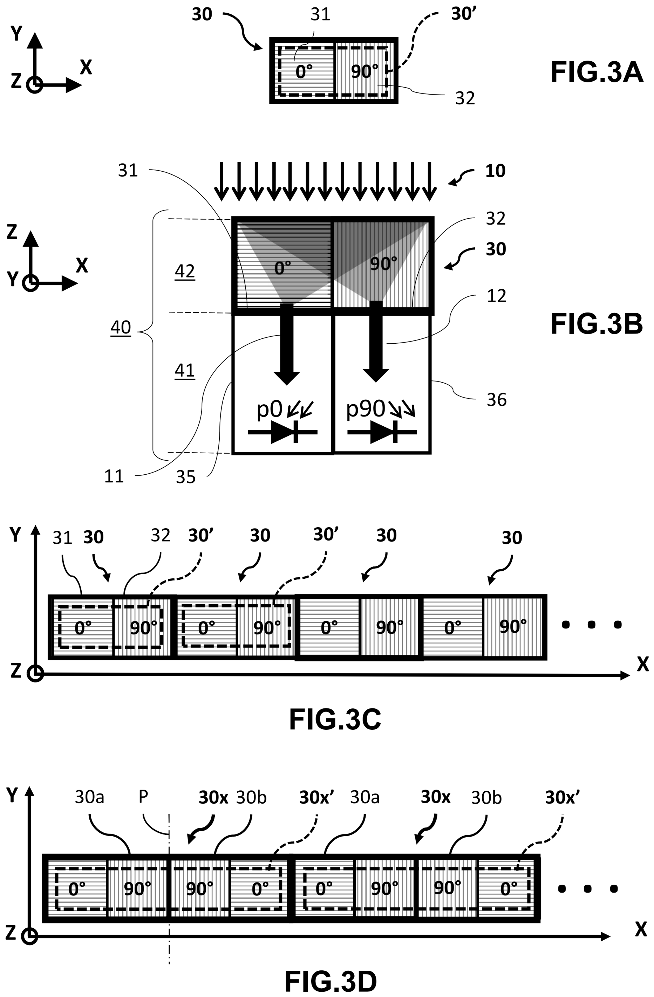

**[****FIG.3A****]** est une représentation schématique, en vue de dessus, d'un motif élémentaire de routage optique en polarisation de format 2×1 (autrement dit d'un motif élémentaire binaire) pouvant être réalisé par une nanostructure comme celle de la FIG.2.
**[****FIG.3B****]** est une représentation schématique simplifiée, en coupe verticale, d'un détecteur optoélectronique en polarisation de la lumière utilisant un routeur optique binaire ayant le motif le routage élémentaire binaire de la FIG.3A, et qui est agencé directement au-dessus de deux pixels associés d'une matrice de pixels sous-jacente du détecteur optique.
**[****FIG.3C****]** est une représentation schématique, en vue de-dessus, d'un dispositif de routage optique en polarisation de la lumière comprenant un agencement formé de la répétition spatiale du motif de routage élémentaire binaire de la FIG.3A suivant une direction de routage déterminée, sans la mise en œuvre de l'invention.
**[****FIG.3D****]** est une représentation schématique, en vue de-dessus, d'un dispositif de routage optique en polarisation de la lumière comprenant un agencement formé de la répétition spatiale du motif de routage élémentaire binaire de la FIG.3A suivant la même direction de routage qu'à la FIG.3B mais avec la mise en miroir de motifs élémentaires adjacents deux-à-deux suivant ladite direction de routage, conformément à la mise en œuvre de l'invention.

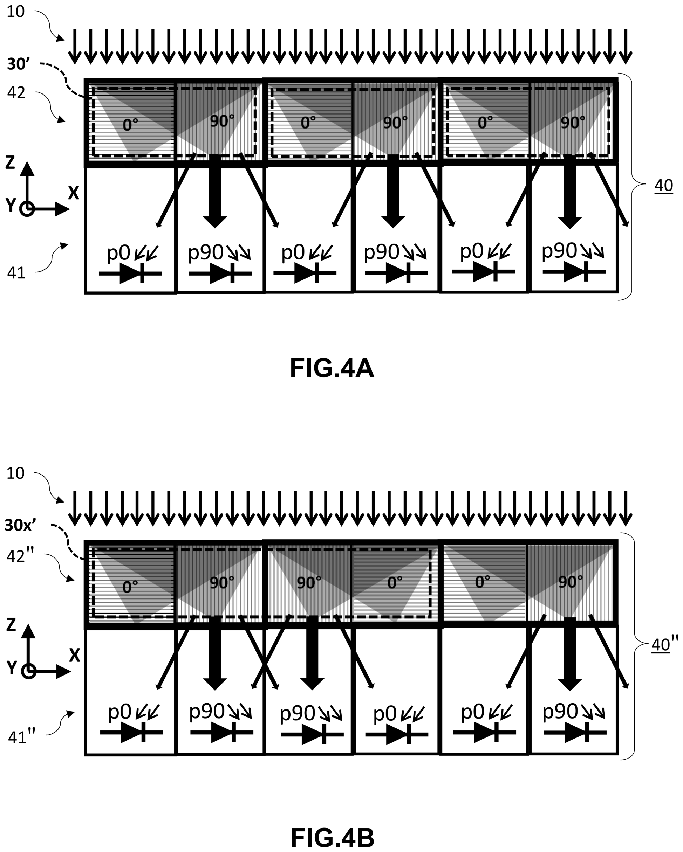

**[****FIG.4A****]** est un schéma simplifié, en coupe verticale, d'un détecteur optoélectronique comprenant le dispositif de routage optique en polarisation de la lumière de la FIG.3C.
**[****FIG.4B****]** est un schéma simplifié, en coupe verticale, d'un détecteur optoélectronique comprenant le dispositif de routage optique en polarisation de la lumière de la FIG.3D.

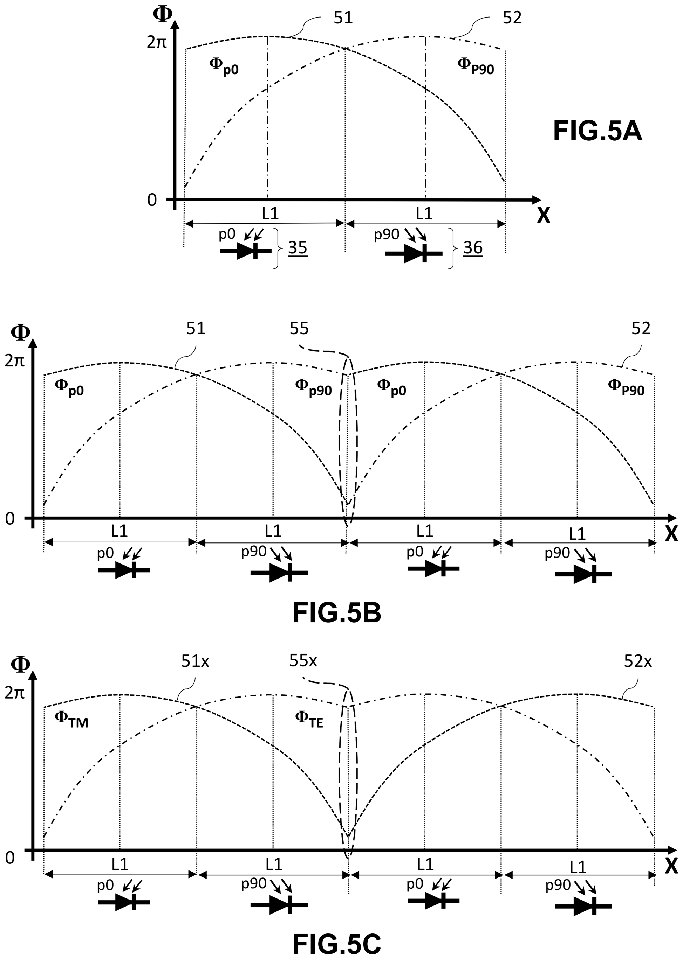

**[****FIG.5A****]** est un diagramme de phase illustrant l'évolution de la phase des composantes électriques polarisées à 0° et à 90° de la lumière suivant la direction de routage optique en polarisation de la lumière dans le détecteur optoélectronique de la FIG.3B.
**[****FIG.5B****]** est un diagramme de phase illustrant l'évolution de la phase des composantes électriques polarisées à 0° et à 90° de la lumière suivant la direction de routage en polarisation de la lumière dans le détecteur optoélectronique de la FIG.3C.
**[****FIG.5C****]** est un diagramme de phase illustrant l'évolution de la phase des composantes électriques polarisées à 0° et à 90° de la lumière suivant la direction de routage en polarisation de la lumière dans le détecteur optoélectronique de la FIG.3D.

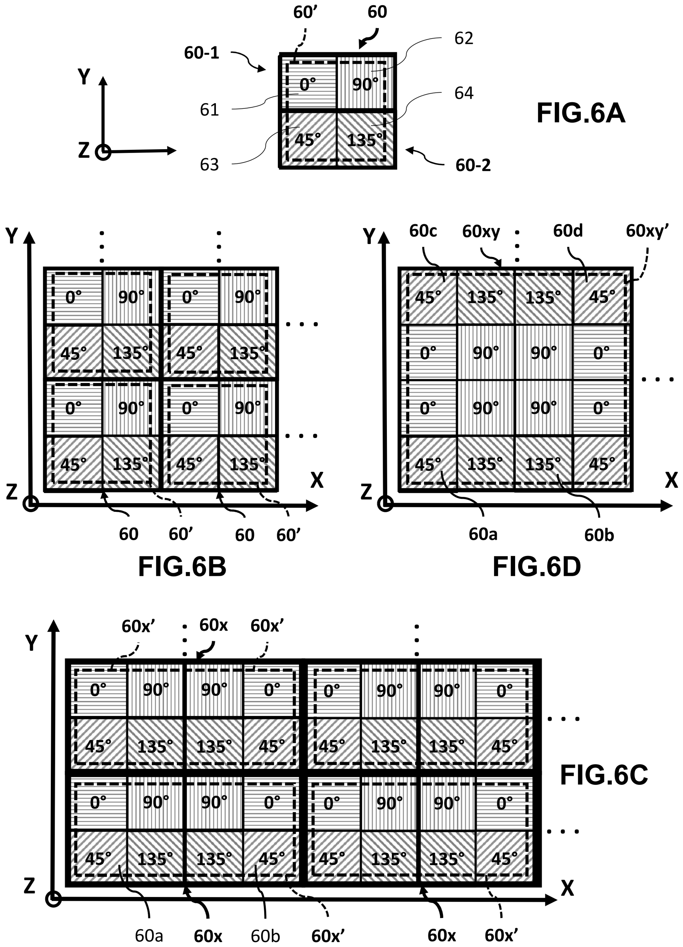

[FIG.6A] est une représentation schématique, en vue de dessus, d'un motif élémentaire de routage optique en polarisation de la lumière de format 2×2 (ou motif élémentaire quaternaire), d'un routage optique sélectif pouvant être réalisé par une nanostructure comme celle de la FIG.2.
**[****FIG.6B****]** est une représentation schématique, en vue de dessus, d'un dispositif de routage optique en polarisation de la lumière comprenant un agencement formé de la répétition spatiale du motif du routage de format 2×2 de la FIG.6A suivant à la fois une première direction déterminée X et suivant une seconde direction Y déterminées perpendiculaires entre elles, sans la mise en œuvre de l'invention.
**[****FIG.6C****]** est une représentation schématique, en vue de-dessus, d'un dispositif de routage optique en polarisation de la lumière comprenant un agencement formé de la répétition spatiale de motifs de routage de format 2×2 comme à la FIG.3B, mais avec mise en miroir de deux motifs élémentaires adjacents suivant la direction X seulement, conformément à des modes de réalisation de l'invention.
**[****FIG.6D****]** est une représentation schématique, en vue de-dessus, d'un dispositif de routage optique en polarisation de la lumière comprenant un agencement formé de la répétition spatiale de motifs de routage élémentaires de format 2×2 comme à la FIG.6B et à la FIG.6C, mais avec la mise en miroir de deux motifs élémentaires adjacents à la fois suivant la direction X et suivant la direction Y, conformément à d'autres modes de réalisation de l'invention.

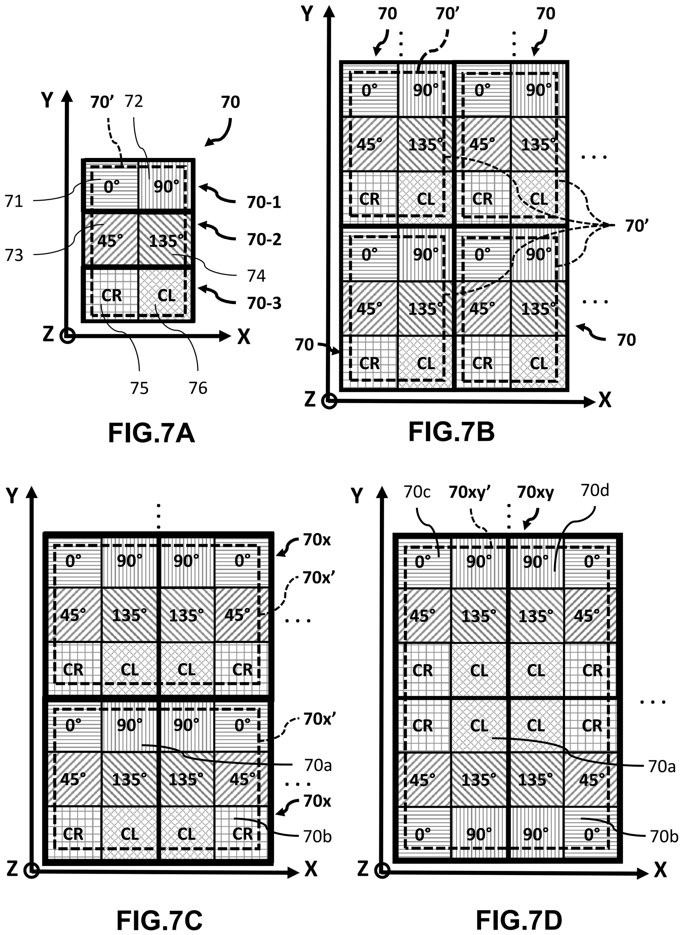

**[****FIG.7A****]** est une représentation schématique, en vue de-dessus, d'un motif élémentaire de routage optique en polarisation de la lumière de format 2×3 (ou motif élémentaire sénaire) d'un dispositif de routage optique sélectif pouvant être réalisé par une nanostructure comme celle de la FIG.2.
**[****FIG.7B****]** est une représentation schématique, en vue de dessus, d'un dispositif de routage optique en polarisation de la lumière comprenant un agencement formé de la répétition spatiale du motif de routage de format 2×3 de la FIG.7A à la fois suivant la direction X et suivant la direction Y, sans la mise en œuvre de l'invention.
**[****FIG.7C****]** est une représentation schématique, en vue de dessus, d'un dispositif de routage optique en polarisation de la lumière comprenant un agencement formé de la répétition spatiale de motifs de routage de format 2×3 comme à la FIG.7B, mais avec la mise en miroir de deux motifs élémentaires adjacents suivant la direction X seulement conformément à des modes de réalisation de l'invention.
**[****FIG.7D****]** est une représentation schématique, en vue de dessus, d'un dispositif de routage optique en polarisation de la lumière comprenant un agencement formé de la répétition spatiale de motifs de routage de format 2×3 comme à laFIG.7C mais avec la mise en miroir de deux motifs élémentaires adjacents à la fois suivant la direction X et suivant la direction Y, conformément à d'autres modes de réalisation de l'invention.

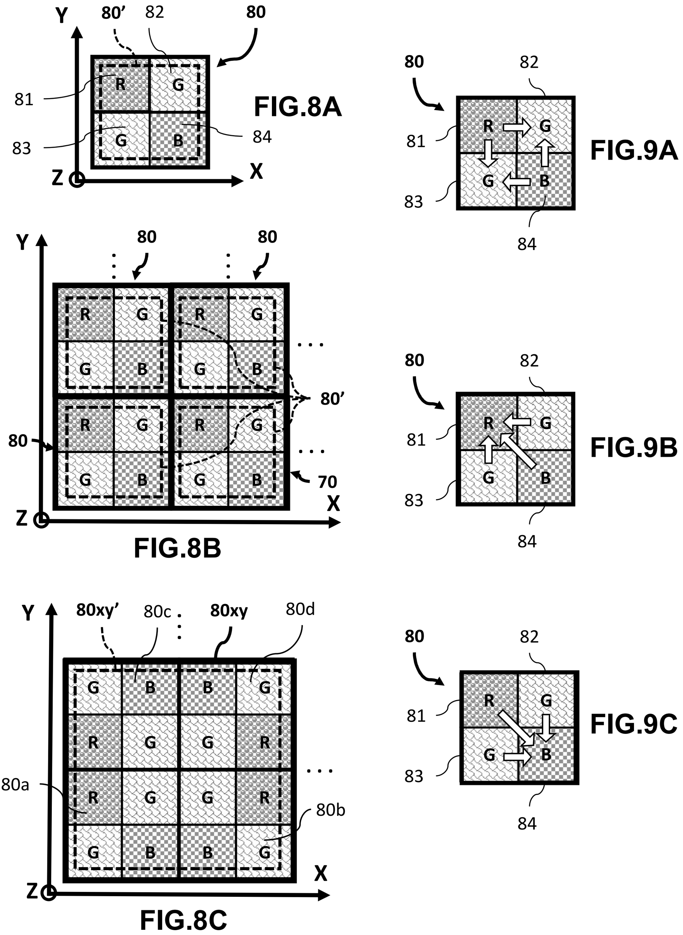

**[****FIG.8A****]** est une représentation schématique, en vue de dessus, d'un motif de routage optique en longueur d'onde de format 2×2 d'un dispositif de routage optique en fonction de trois longueurs d'onde respectives pouvant être réalisée par une nanostructure comprenant une méta-surface similaire à celle de la FIG.2.
**[****FIG.8B****]** est une représentation schématique, en vue de dessus, d'un dispositif de routage optique en longueur d'onde de la lumière comprenant un agencement formé de la répétition spatiale du motif de routage de format 2×2 de la FIG.8A suivant à la fois la direction X et suivant la direction Y, sans la mise en œuvre de l'invention.
**[****FIG.8C****]** est une représentation schématique, en vue de dessus, d'un dispositif de routage optique en longueur d'onde de la lumière comprenant un agencement formé de la répétition spatiale de motifs de routage de format 2×2 comme à la FIG.8B, mais avec la mise en miroir de deux motifs élémentaires adjacents à la fois suivant la direction X et suivant la direction Y, conformément à des modes de réalisation de l'invention.
**[****FIG.9A]**, **[FIG.9B]** et **[FIG.9C****]** sont des représentations schématiques, en vue de dessus, du motif de routage optique en longueur d'onde de la FIG.8A illustrant des règles de routage optique en longueur d'onde de la lumière, pour trois longueurs d'onde différentes qui sont traitées par le routeur optique en longueur d'onde correspondant.

### Description des modes de réalisation

Dans la description de modes de réalisation qui va suivre et dans les figures des dessins annexés, les mêmes éléments ou des éléments similaires portent les mêmes signes de référence.

On définit ici et pour la suite de la description un repère direct tridimensionnel orthogonal (X,Y,Z), communément lié au sol de la Terre. Dans ce repère, les axes X et Y forment un plan parallèle au plan de la surface sensible du détecteur optoélectronique lorsqu'il est disposé à plat suivant l'horizontale. De plus, l'axe Z est orienté ici de manière orthogonale audit plan de la surface sensible du détecteur optique, et suivant l'axe de la gravité. Dans la suite de la description, les termes "vertical" et "verticalement" s'entendent comme étant relatifs à une orientation sensiblement parallèle à l'axe Z, et les termes "horizontal" et "horizontalement" comme étant relatifs à une orientation sensiblement parallèle au plan (X,Y). Par ailleurs, les termes "supérieur" et "inférieur", "haut" et "bas", "dessus" et "dessous" et tous les termes dérivés et les expressions dérivées comme "en haut" et "en bas", ou "au-dessus" et "au-dessous", par exemple, s'entendent comme se rapportant à un positionnement croissant ou décroissant, respectivement, de deux éléments par rapport au support de base du photodétecteur suivant la direction +Z. Les termes "latéral" et "latéralement", ainsi que les expressions "à-côté de" ou "adjacent(e)" ou encore les termes "contigu/contigüe" et les expressions les incorporant, s'entendent comme se rapportant à un positionnement relatif de deux éléments suivant l'axe X et/ou l'axe Y du plan horizontal (X,Y), sauf mention contraire spécifique.

La lumière est une onde qui se propage dans l'espace, selon une direction précise, que l'on choisit être ici la direction verticale Z orientée vers le bas dans les figures des dessins annexés, c'est-à-dire qu'elle illumine la surface du photodétecteur de manière sensiblement orthogonale et du haut vers les bas. Ceci correspond à un cas d'usage d'un détecteur optoélectronique lorsqu'il est posé à plat sur une table, par exemple, avec sa surface sensible tournée vers le haut. La direction de propagation Z est perpendiculaire au plan d'onde. Dans les illustrations données ici, ce plan d'onde correspond donc au plan horizontal (X,Y) de la surface sensible d'un détecteur optoélectronique. Les détecteurs optoélectroniques sont sensibles à la valeur moyenne, dans le temps, du carré du champ électrique : c'est l'intensité lumineuse.

Un détecteur optoélectronique est classiquement un détecteur à au moins deux dimensions (2D). En tant que tel, il comprend au moins une matrice de photodétecteurs (ou pixels) agencés en lignes s'étendant suivant une première direction et en colonnes s'étendant suivant une seconde direction, différente de ladite première direction. Dans les exemples illustrés, ces deux directions sont la direction X et la direction Y, respectivement, lesquelles définissent le plan de la surface sensible du détecteur. On notera que les modes de réalisation ne sont pas limités à des détecteurs optiques 2D, mais sont compatibles avec des détecteurs optiques à trois dimensions (3D) comprenant au moins deux matrices de photodétecteurs superposées suivant la direction verticale Z.

Comme toute onde électromagnétique (EM) qui se propage, la lumière est constituée d'un champ électrique *̅E̅*̅ et d'un champ magnétique *̅B̅*̅ associés, perpendiculaires entre eux, et chacun orthogonal à la direction de propagation *̅v̅*̅ de l'onde. Comme toutes les ondes, en outre, une onde lumineuse peut s'analyser en utilisant les méthodes et outils mathématiques de l'analyse spectrale : on peut ainsi décomposer une onde lumineuse quelconque en ondes dites ondes planes "monochromatiques" c'est-à-dire en ondes ayant chacune une fréquence pure (*i.e.,* une unique longueur d'onde).

En référence au schéma de la FIG.1, une onde électromagnétique monochromatique 11 peut se modéliser par un dipôle électrostatique vibrant 12. La figure illustre l'oscillation couplée du champ électrique *̅E̅*̅ et du champ magnétique *̅B̅*̅ d'une telle onde, suivant le modèle du dipôle vibrant le long de la direction de propagation *̅v̅*̅ (le trièdre {*E̅ , B̅, v̅*} étant un dièdre direct). Les variations des champs électriques et magnétiques sont liées entre elles par les équations de Maxwell. On peut donc représenter et étudier l'onde par un seul de ces deux champs. Ainsi on décide souvent, par convention, d'ignorer le champ magnétique, car il peut être déterminé à partir du champ électrique. On considérera donc ici uniquement le champ électrique *̅E̅*̅ perpendiculaire à la direction de propagation Z.

Dans un milieu homogène et isotrope, toute onde électromagnétique se propage en ligne droite. Lors de la rencontre avec un obstacle, il y a diffraction. Lors d'un changement de milieu, il y a réflexion et réfraction. Il y a aussi réfraction si les propriétés du milieu changent selon l'endroit (*i.e.,* en cas hétérogénéité du milieu de propagation) : la lumière est déviée lorsqu'elle passe d'un milieu à un autre, ces milieux respectifs ayant des vitesses de phase différentes sur le plan chimique ou physique (densité, impédance, ...).

Pour l'étude des phénomènes liés à la propagation optique comme ceux évoqués ci-dessus, la notion d'onde électromagnétique est complémentaire de celle de photon : c'est la dualité onde-corpuscule de la lumière. En fait, l'approche ondulatoire fournit une description plus pertinente de la radiation pour les faibles fréquences (c'est-à-dire les grandes longueurs d'onde) comme les ondes radio. Mais en réalité, l'onde électromagnétique représente deux notions distinctes à la fois, à savoir :
- la variation macroscopique du champ électrique *̅E̅*̅ et du champ magnétique *̅B̅*̅ présentée ci-dessus, qui est traitée selon une approche ondulatoire; et,
- la fonction d'onde du photon, c'est-à-dire la norme au carré de l'onde, qui est la probabilité de présence d'un photon, et qui est traitée selon une approche corpusculaire.

Dans le domaine de l'optique, où la lumière correspond à des radiations d'ondes électromagnétiques à des fréquences plus élevées que les radiofréquences, lorsque le flux d'énergie est grand devant l'énergie individuelle des photons on peut considérer que l'on a un flux quasi-continu de photons, et les deux notions ci-dessus se recouvrent. Ceci n'est plus vrai, toutefois, lorsque le flux d'énergie de la radiation est faible (par exemple dans les applications où les photons sont envoyés un par un). En effet, la notion de variation macroscopique (moyenne) du flux de photons n'a alors plus de sens. Et l'approche ondulatoire pour l'étude des phénomènes liés à la propagation est alors écartée, au profit de l'approche corpusculaire qui fait appel aux règles de la physique quantique.

Par ailleurs, la polarisation de la lumière est une propriété qu'ont les ondes vectorielles *(i.e.,* les ondes qui peuvent osciller selon plus d'une orientation) de présenter une répartition privilégiée de l'orientation des vibrations qui les composent. Ainsi la lumière, comme toutes les ondes électromagnétiques, a des propriétés de polarisation. La polarisation d'une onde EM est donnée par le comportement dans le temps de son champ électrique *̅E̅*̅. Plus précisément, la polarisation de l'onde est caractérisée par la trajectoire de l'extrémité du champ électrique *̅E̅*̅ de l'onde, dans le plan d'onde. En d'autres termes, la polarisation correspond à la direction et à l'amplitude du champ électrique *̅E̅*̅. Pour une onde non polarisée, ou onde naturelle, le champ *̅E̅*̅ tourne autour de son axe de façon aléatoire et imprévisible au cours du temps. Une onde polarisée correspond à une onde présentant une trajectoire définie du champ électrique. Il existe trois types de polarisation :
- la polarisation rectiligne ou linéaire : le champ électrique *̅E̅*̅ est toujours orienté selon la même direction ;
- la polarisation circulaire : le champ électrique *̅E̅*̅ a une amplitude constante et tourne autour de son axe en formant un cercle ; et,
- la polarisation elliptique : le champ électrique *̅E̅*̅ tourne autour de son axe et change d'amplitude pour former une ellipse.

Classiquement, on décrit les phénomènes ondulatoires de la lumière en référence à des courbes qui donnent une représentation spatiale, instantanée, au temps fixé, des positions de la pointe de flèche du vecteur représentant le champ électrique *̅E̅*̅ dans tous les plans d'onde superposés verticalement le long de la direction de propagation Z. Ces courbes sont construites en reportant à la distance verticale le vecteur champ qui existait dans le plan d'onde à un instant passé (si bien qu'on tient ainsi compte de l'effet de la propagation) :
- la courbe qui représente la polarisation rectiligne est une sinusoïde tracée dans le plan vertical ;
- la courbe qui représente la polarisation circulaire est une hélice qui s'enroule sur un cylindre vertical, dont la base est un cercle ; et,
- la courbe qui représente la polarisation elliptique est une courbe ressemblant à une hélice, tracée sur un cylindre vertical, aplati, dont la base est une ellipse.

Considérant les deux composantes vectorielles *̅E̅_̅{̅X̅}̅*̅ et *̅E̅_̅{̅Y̅}̅*̅ qui définissent l'orientation du champ électrique *̅E̅*̅ dans le plan d'onde (X,Y), la figure décrite au cours du temps par le champ électrique *̅E̅*̅ en un point donné peut alors être :
- un segment de droite, dans le cas par exemple de la polarisation rectiligne qui est illustré à la **FIG.1** ;
- un cercle, dans le cas de la polarisation circulaire; ou,
- une ellipse, dans celui de la polarisation elliptique.

En résumé, dans une onde électromagnétique (EM), le champ électrique *̅E̅*̅ et le champ magnétique *̅B̅*̅ oscillent simultanément dans des directions perpendiculaires l'une à l'autre. Par convention, la polarisation de la lumière décrit la vibration du champ électrique *̅E̅*̅. L'onde est polarisée linéairement quand elle n'a qu'une composante *̅E̅_̅{̅X̅}̅*̅ ou *̅E̅_̅{̅Y̅}̅*̅ c'est-à-dire que le champ électrique *̅E̅*̅ oscille dans une seule des directions X et Y. Quand une onde est constituée de deux composantes *̅E̅_̅{̅X̅}̅*̅ et *̅E̅_̅{̅Y̅}̅*̅ polarisées à 90° l'une de l'autre et que ces deux composantes sont également en déphasage de 90° l'une par rapport à l'autre, alors sa polarisation semble tourner autour de la direction de propagation de l'onde et on parle dans ce cas de polarisation elliptique, ou de polarisation circulaire quand les deux composantes ont, en outre, la même intensité. Le sens de la rotation, droite ou gauche, dépend du sens du déphasage entre les deux composantes, qui dépend également des propriétés et de l'activité optique des milieux traversés. Les polarisations circulaire et linéaire sont des cas particuliers de la polarisation elliptique : dans le premier cas les deux composantes *̅E̅_̅{̅X̅}̅*̅ et *̅E̅_̅{̅Y̅}̅*̅ sont d'amplitudes égales, et dans le second cas l'une des composantes *̅E̅_̅{̅X̅}̅*̅ et *̅E̅_̅{̅Y̅}̅*̅ est nulle. Par ailleurs, une onde de polarisation elliptique peut être vue comme la somme d'une polarisation circulaire et d'une polarisation linéaire.

Dans les exemples de mise en œuvre donnés ici, le détecteur optique est un capteur optoélectronique dans lequel la séparation des états de polarisation de la lumière captée a lieu directement au niveau de la surface sensible du capteur optoélectronique, à l'échelle du photodétecteur élémentaire ou pixel. Il peut s'agir, sans que cela soit limitatif, d'un capteur d'image en technologie CMOS, par exemple. Il peut s'agir également, en variante, d'un capteur d'image du type d'un dispositif à transfert de charges (ou CCD, mis pour "*Charge Coupled Device*" en anglais). D'autres applications peuvent être envisagées dans des dispositifs photoniques à fibre(s) optique(s) ou guide(s) d'onde(s) optique(s).

On va maintenant présenter le dispositif de routage de la lumière en polarisation ou en longueur d'onde. Un tel dispositif opère une déviation spatiale de l'onde lumineuse (des photons) en fonction de la polarisation ou de la longueur d'onde de la lumière incidente. Il permet de modifier la distribution de l'illumination des pixels par la lumière, celle-ci étant sélectivement routée, c'est-à-dire déviée préférentiellement vers certains pixels en fonction de la polarisation ou en fonction de sa longueur d'onde, lors du passage à travers le dispositif de routage optique.

Les modes de réalisation qui vont maintenant être décrits peuvent faire usage de la technologie des méta-surfaces pour réaliser le dispositif de routage optique proposé. Les méta-surfaces sont des composants photoniques fonctionnels capables de manipuler toutes les propriétés de la lumière, à savoir non seulement l'amplitude et/ou la longueur d'onde, mais aussi la phase et/ou la polarisation. D'autres technologies de réalisation pourraient éventuellement être envisagées, notamment des technologies de réalisation connues dans le domaine de la microélectronique et des nanotechnologies en général, et de la nanophotonique en particulier, mais il n'en est pas considéré ici.

La **FIG.2** donne une représentation en coupe simplifiée d'une méta-surface (MS) intégrée à un détecteur optoélectronique. En référence à la figure, la méta-surface 20 est réalisée à partir de l'agencements d'éléments diffusants, c'est-à-dire de structures atomiques à l'échelle nanoscopique (ou méta-atomes) diffusant la lumière. Ces éléments prennent la forme de piliers nano structurés 22 (on parle aussi de nano-piliers). Ils ont des tailles et des périodicités de répartition spatiale en surface qui sont inférieures à la longueur d'onde de la lumière considérée (on parle de taille "sous-longueur d'onde"). Une méta-surface est donc un pavage d'éléments optiquement actifs ayant un indice de diffraction élevé (*i.e.,* les nano-piliers), et d'éléments ayant un indice de diffraction faible (*i.e.,* les espaces entre lesdits nano-piliers, ou interstices spatiaux), qui sont en un matériau interstitiel différent.

Dans le contexte de la fabrication de routeurs optiques en fonction de la polarisation ou en fonction de la longueur d'onde de la lumière, les paramètres géométriques et les arrangements périodiques des nano-piliers permettent de contrôler la phase, ou front d'onde *(*"*Wavefront*" en anglais), d'un faisceau lumineux incident. Ainsi, une méta-surface est spécialement conçue pour produire une phase, *i.e.,* un front d'onde, via le placement et la variation de la taille des nano-piliers 22. Les caractéristiques de phase sont déterminées au préalable, selon la fonction de routage optique que l'on cherche à obtenir, pour la caractéristique optique de la lumière considérée (par exemple la longueur d'onde et/ou la polarisation). La fabrication d'une méta-surface se fait à l'aide de processus de nano-fabrication, incluant une étape de gravure des nanostructures sur un substrat. L'exposé de ces processus sortirait du cadre de présente description.

En référence à la **FIG.2**, les nano-piliers 22 sont formés au-dessus de, ou dans la partie supérieure d'un support appelé le piédestal 21 (ou "*spacer*" en anglais), dont l'épaisseur h1 suivant la direction Z est de quelques micromètres (µm) ou microns. Le piédestal 21 est formé au-dessus de photodétecteurs (pixels) 25 et 26. Ces photodétecteurs peuvent être, par exemple, des photodiodes réalisées conventionnellement en technologie CMOS. La dimension des pixels 25 et 26 suivant la direction X, ou longueur L1, peut être de quelques microns (µm). Les nano-piliers 22 sont recouverts d'une ou plusieurs couches additionnelles 23, par exemple au moins une couche de matériau anti-réflectif et au moins une couche de passivation. L'épaisseur totale h3 de ce complexe de couches supérieures, considérée suivant la direction Z, peut être de quelques centaines de nanomètres (nm). Eu égard à leurs principales propriétés physiques, ces couches peuvent être désignées collectivement par le vocable "anti-réflectif", ce qui est plus ou moins un abus de langage mais rend compte d'une certaine réalité fonctionnelle.

Les nano-piliers 22 eux-mêmes ont une hauteur h2 suivant la direction Z, qui peut être comprise entre environ 100 nm et environ 1500 nm, voire plus, selon le besoin dans l'application considérée. Le matériau dont sont faits les nano-piliers 22 dépend également du besoin et de la longueur d'onde de la lumière 10 considérée. Ainsi, par exemple :
- pour de la lumière dans le spectre infrarouge proche (dit spectre "proche IR"), il s'agit généralement de nanoparticules de silicium (Si) amorphe ;
- pour de la lumière dans le spectre visible, il peut s'agir, de manière non-limitative, de Nitrure de Silicium (SiN), de dioxyde de Titane (TiO2), d'Oxyde d'Aluminium ou Alumine (Al2O3), etc.

Dans le jargon de la personne du métier, ce qu'on entend généralement par "méta-surface" se limite à la nanostructure 20 formée de l'agencement des nano-piliers 22 et du matériau qui englobe lesdits piliers dans le plan horizontal qui les contient, mais exclut le piédestal 21 au-dessus duquel les nano-piliers 22 sont réalisés. Et ce en dépit du fait que ledit piédestal peut éventuellement être fait du même matériau que le matériau interstitiel présent entre lesdits piliers 22, par exemple du dioxyde silicium (SiO2). Le piédestal peut aussi être fait d'un matériau différent dudit matériau interstitiel, selon les besoins propres à chaque application et selon les procédés technologiques de fabrication mis en œuvre. Cela peut être tout matériau semiconducteur ou diélectrique dont les propriétés correspondent aux besoins, lesquels comprennent en général un indice de réfraction d'intérêt, la facilité du dépôt en phase de fabrication, et/ou une transparence *(i.e.,* une absorption nulle) à la longueur d'onde de travail. De même, la couche ou plutôt la pile de couches 23 qui est formée au-dessus des nano-piliers 22, est généralement exclue de la définition de la méta-surface selon l'acception de ce terme qui est actuellement la plus répandue.

Une structure d'interconnexion 27 située sous les pixels 25 et 26 comprend les métallisations du circuit de lecture des pixels. Ces métallisations sont généralement réalisées en métal, tel que le cuivre (Cu) ou l'aluminium (Al). Elles comprennent des lignes métalliques horizontales formées dans des niveaux de métallisation empilés suivant la direction verticale Z, qui sont isolés les uns des autres par des couches intercalaires de matériau diélectrique (isolant électrique). Généralement, le matériau diélectrique est du dioxyde de silicium (SiO2), mais il peut s'agit de tout autre oxyde ou même d'un autre type de matériaux de matériau diélectrique, comme un nitrure par exemple. Les métallisations comprennent en outre des connections verticales (ou "*vias*") qui relient électriquement des métallisations horizontales entre elles, et aux circuits actifs réalisés dans les couches inférieures (non détaillées ici). Ces métallisations verticales traversent une ou plusieurs couches de matériau diélectrique.

On notera que l'une des causes de couplage réciproque entre pixels adjacents dans un détecteur optoélectronique réside dans le fait que la lumière incidente non absorbée par les photodiodes des pixels 25 et 26 est réfléchie par des lignes métalliques de la structure d'interconnexion 27 et repart vers le haut, puis est à nouveau partiellement réfléchie par les couches supérieures dans les pixels adjacents. Cette lumière réfléchie "pollue" l'effet de la lumière incidente, en réduisant le taux de rejection offert par le routage de la lumière qui est recherché.

Un routeur de la lumière ou routeur optique est un dispositif optique ayant une entrée optique et au moins deux sorties optiques et qui est adapté, par conception, pour trier en sortie la lumière reçue en entrée en fonction d'un paramètre de la lumière incidente, comme son état de polarisation (*i.e.,* sa polarisation) ou sa longueur d'onde (*i.e.,* sa "couleur"). La lumière n'est pas intentionnellement filtrée, c'est-à-dire que l'essentiel de l'intensité lumineuse reçue en entrée est transmis en sortie, à travers le routeur optique. La lumière est simplement triée, c'est-à-dire qu'elle est intentionnellement déviée, sélectivement, une partie du flux lumineux incident étant transmis préférentiellement vers une sortie optique alors qu'une autre partie dudit flux est transmis préférentiellement vers l'autre sortie optique (ou vers l'une des autres sorties optiques du routeur, le cas échéant), en fonction de la polarisation ou de la longueur d'onde de la lumière.

Dans les modes de réalisation, ce dispositif optique s'utilise en combinaison avec des photodétecteurs ou pixels indépendants, à savoir au moins deux pixels indépendants l'un de l'autre et respectivement associés à chacune des deux zones de sortie optique du routeur (plus généralement, un pixel est associé à chaque zone de sortie optique du routeur). Ainsi agencés, les pixels permettent chacun de détecter de façon privilégiée la lumière avec une polarisation ou l'autre polarisation (ou l'une des autres polarisations, le cas échéant), ou bien la lumière à une longueur d'onde déterminée ou à une autre longueur d'onde (ou l'une des autres longueurs d'onde, le cas échéant). Bien entendu, une partie du flux incident peut être transmise à travers le routeur sans être effectivement routée vers le pixel prévu, voire sans être routée du tout, *i.e.,* sans déviation particulière, soit en raison d'imperfections inhérentes du routeur, soit parce que cette partie du flux incident ne satisfait à aucun des critères de routage définis par la conception du routeur. Ceci sera le cas, par exemple, avec un routeur prévu pour trier quelques longueurs d'onde déterminée dans un flux lumineux incident dont le contenu fréquentiel est plus large, *i.e.,* qui contient d'autres longueurs d'onde que celles que le routeur est conçu pour séparer.

La personne de métier appréciera en considérant l'exemple de la **FIG.2** que l'entrée optique du routeur optique qui, dans cet exemple, est défini par la méta-structure 20 dans le détecteur optoélectronique représenté, est définie par sa surface supérieure. Dit autrement, cette surface supérieure constitue sa zone d'entrée optique, en ce sens que la lumière incidente pénètre dans le routeur optique via cette surface. En revanche, ses différentes sorties optiques sont définies par des portions ou zones respectives de sa surface inférieure, qui viennent chacune au droit de l'un des photodétecteurs (pixels) associés 25 et 26. Avantageusement, en cas d'utilisation du routeur optique dans un détecteur optoélectronique, les zones de sortie optique du routeur optique sont de préférence directement au-dessus de leurs pixels associés respectifs, c'est-à-dire en couplage optique direct avec la partie active desdits pixels. Par "couplage optique direct " on entend que le couplage optique des zones de sortie du routeur avec les pixels associés sous-jacents, est réalisé sans l'interposition d'un élément intermédiaire tel qu'une lentille ou un autre élément optique similaire. C'est donc par commodité et par une forme d'abus de langage que l'on parlera parfois de "flux lumineux" séparés en sortie du routeur, car il n'y a pas à proprement parler de flux lumineux distincts qui sont créés, la lumière triée par le routeur optique étant immédiatement convertie en signaux électriques distincts par les pixels sous-jacents. Bien entendu, cette remarque n'empêche pas que, dans certaines applications, on puisse "empiler" d'autres structures pour réaliser d'autres fonctions optiques en plus du routage optique de la lumière. On peut par exemple empiler un routeur et des microlentilles pour améliorer la tenue en angle, et/ou un filtre pour affiner la réponse du routeur.

Dans l'exemple illustré schématiquement par la **FIG.2**, la méta-surface 22 qui est formée au-dessus des pixels 25 et 26 est conçue pour router (c'est-à-dire dévier) la lumière incidente, en fonction de sa polarisation, soit dans le pixel 25, soit dans l'autre pixel 26. Les deux polarisations considérées sont par exemple des polarisations linéaires orthogonales. Plus particulièrement, dans l'exemple représenté à la FIG.2, la polarisation linéaire à 0° est routée dans le pixel gauche 25 (celui représenté à gauche de la figure) alors que la polarisation linéaire à 90° est routée dans le pixel droit 26 (celui représenté à droite de la figure).

Le taux d'extinction en polarisation (ou PER, de l'anglais "*Polarization Extinction Ratio*") est défini, par pixel, comme le rapport entre la quantité de lumière captée avec la polarisation souhaitée sur la quantité de lumière captée avec la polarisation non souhaitée. Le PER du pixel de gauche 25 est donc le rendement quantique (ou QE, mis pour "*Quantic Efficiency*" qui signifie efficacité quantique en anglais) du pixel de gauche illuminé sous une lumière polarisée à 0°, divisé par le QE dudit pixel de gauche 25 illuminé sous une lumière polarisée à 90°. On procède de la même manière pour déterminer le PER du pixel de droite 26. On rappelle que, pour un photodétecteur (pixel), le QE rend compte de l'efficacité de la transformation lumière/charge électrique, donnée par le nombre d'électrons produits dans le photodétecteur rapporté au nombre de photons dans le flux de lumière incident. On appréciera que, dans le cas idéal d'un routage optique parfait, le PER de chacun des pixels 25 et 26 serait infini.

La personne du métier appréciera en outre que la composition des méta-surfaces formant les routeurs de la lumière dépend des spécificités de chaque application, notamment du critère de routage optique de la lumière qui est souhaité, de la taille des pixels, de la (ou des) longueur(s) d'onde de travail, de l'incidence de la lumière en entrée, de sa polarisation, etc. Décrire la réalisation détaillée d'une nanostructure de routage en fonction de ces différentes caractéristiques n'est pas utile et sortirait du cadre de la présente divulgation.

On va maintenant définir plusieurs niveaux d'unités de routage optique, tant à des fins lexicographiques que d'un point de vue fonctionnel pour expliciter les effets techniques qui sont à la base de l'invention et qui seront développés plus loin.

L'unité de routage optique la plus élémentaire, c'est-à-dire un routeur optique minimaliste ayant une zone d'entrée optique et seulement deux zones de sortie optique pour trier la lumière incidente en fonction de deux valeurs distinctes respectives d'une caractéristique optique considérée, forme ce qui est appelé dans la suite un "routeur binaire". C'est un routeur optique élémentaire qui est adapté pour trier la lumière incidente reçue sur la zone d'entrée optique en fonction de sa polarisation parmi deux états de polarisation donnés ou en fonction de sa longueur d'onde parmi deux longueurs d'onde déterminées, en combinaison avec les deux pixels associés qui sont disposés en-dessous des deux zones de sortie du routeur binaire.

Par ailleurs, on désigne par "motif de routage binaire", la configuration spatiale, appréciée dans le plan de la surface sensible du détecteur optoélectronique qui est parallèle au plan horizontal (X,Y) dans les exemples représentés aux figures, des deux zones de sortie optique du routeur optique binaire. Cette configuration spatiale est adaptée pour séparer la lumière en sortie du routeur binaire en deux pseudo "sous-flux" lumineux distincts, en discriminant des valeurs respectives distinctes d'un des paramètres optiques, *i.e.,* polarisation ou longueur d'onde dans les exemples considérés ici, de la lumière incidente qui est reçue sur la zone d'entrée. La personne du métier appréciera qu'il s'agit aussi, et corrélativement, de la configuration spatiale de leurs deux pixels associés dans la matrice de photodétecteurs sous-jacente, à savoir les pixels associés 25 et 26 dans l'exemple montré à la FIG. 2.

La direction suivant laquelle les deux zones de sortie optique du routeur élémentaire sont disposées côte-à-côte (on peut dire qu'elles sont "alignées" suivante ladite direction), et par conséquent la direction suivant laquelle les deux pixels qui leur sont respectivement associés dans la matrice de photodétecteurs sont alignés, est appelée la direction de routage. C'est en effet suivant cette direction qu'une partie de la lumière incidente est déviée spatialement par le routeur optique, en fonction de son état de polarisation ou en fonction de sa longueur d'onde. Dans les modes de réalisation donnés dans la présente description en référence aux figures des dessins, cette direction est la direction X ou la direction Y, lesquelles définissent le plan de la matrice photosensible du détecteur optoélectronique.

Dans ce qui suit, la notation 1×2 et la notation 2×1 désignent ce que l'on appelle le "format" du routeur optique binaire, ou le "format" du motif de routage dudit routeur optique. Le premier chiffre désigne le nombre de zones de sortie optique du routeur optique binaire présente(s) suivant la première direction X de la matrice de photodétecteurs (direction des lignes de la matrice). Le second chiffre désigne le nombre de zones de sortie optique du routeur optique binaire présente(s) suivant la seconde direction Y de la matrice de photodétecteurs (direction des colonnes de la matrice). Ainsi, un routeur optique binaire de format 1×2 est un routeur optique binaire dont le motif de routage comprend deux zones de sortie optique disposées en colonne, c'est-à-dire qu'elles sont alignées suivant la direction Y. Inversement, un routeur optique binaire de format 2×1 est un routeur optique binaire dont le motif de routage comprend deux zones de sortie optique disposées en ligne, c'est-à-dire qu'elles sont alignées suivant la direction X.

Lorsque le dispositif de routage optique est un dispositif de routage en polarisation de la lumière, un routeur optique binaire est généralement adapté pour trier en sortie, par routage optique c'est-à-dire par déviation optique sélective vers l'une de ses deux zones de sortie optique, la lumière reçue au niveau de sa zone d'entrée optique en fonction de sa polarisation parmi deux états de polarisation croisés respectifs. Par exemple, grâce à ses deux zones de sortie optique, un routeur optique binaire peut être adapté pour trier en sortie, par routage optique, la lumière incidente reçue au niveau de sa zone d'entrée optique en fonction de la polarisation de ladite lumière incidente parmi des couples d'états de polarisation linéaire orthogonaux entre eux, par exemple les polarisations à 0° et à 90°, respectivement, ou les états de polarisation à 45° et à 135°, respectivement, ou encore parmi la polarisation circulaire gauche (ou CL, mis pour "*Circular Left*" en anglais) et la polarisation circulaire droite (ou CR, mis pour "*Circular Right*" en anglais), respectivement. D'autres couples d'états de polarisation linéaire orthogonaux entre eux peuvent être considérés suivant les besoins de chaque application, et l'invention n'est pas limitée aux exemples ci-dessus.

Pour la clarté de la description qui suit de modes de réalisation non limitatifs, on considérera dans la suite, en référence aux schémas de la **FIG.3A** à la **FIG.3D****,** de la **FIG.4A** à la **FIG.4B****,** et de la **FIG.5A** à la **FIG.5C**, le cas d'un routeur optique binaire adapté pour trier en sortie la lumière incidente reçue en entrée en fonction de sa polarisation parmi deux états de polarisation linéaires croisés qui sont la polarisation à 0° et la polarisation à 90°, respectivement.

Selon les applications, on peut avoir besoin de séparer plus de deux états de polarisation de la lumière incidente, par exemple parmi une pluralité de couples d'états de polarisation linéaire croisés entre eux. Il peut s'agir, par exemple, des états de polarisation linéaire orthogonaux à 0° et à 90°, respectivement, et des états de polarisation linéaire orthogonaux à 45° et à 135°, respectivement, et/ou de la polarisation circulaire gauche (CL) et de la polarisation circulaire droite (CR), respectivement. Dans ce cas, le routeur optique élémentaire est une cellule élémentaire de routage optique plus large qu'un routeur optique binaire, c'est-à-dire de format supérieur à 1×2 ou 2×1. Il comprend par exemple autant de routeurs optiques binaires différents qu'il y a de couples différents d'états de polarisation croisés à séparer. Par exemple, ces routeurs optiques binaires différents sont disposés côte-à-côte, c'est-à-dire adjacents deux-à-deux, dans le plan du routeur optique élémentaire ainsi formé, parallèlement à la surface sensible de la matrice de photodétecteurs, au-dessus de ladite matrice.

Par extension de la notion de "motif de routage binaire" pour un routeur binaire qui a été introduite plus haut, un "motif de routage élémentaire " désigne la configuration spatiale, appréciée dans le plan de la surface sensible du détecteur optoélectronique, des divers couples de zones de sortie optique du routeur élémentaire. Il s'agit aussi, corrélativement, de la configuration spatiale de leurs pixels associés sous-jacents au sein de la matrice 2D de photodétecteurs. Cette configuration spatiale permet de générer en sortie du routeur élémentaire des couples de pseudo "sous-flux" lumineux distincts en discriminant pour chacun de ces couples deux états de polarisation distincts qui sont présents dans le flux lumineux d'entrée.

Pour illustrer ces modes de réalisation par un premier exemple, on considérera plus loin, en référence aux schémas de la **FIG.6A** à la **FIG.6D**, l'exemple non limitatif d'un routeur optique élémentaire adapté pour trier en sortie la lumière incidente en fonction de sa polarisation parmi quatre états de polarisation linéaire orthogonaux deux-à-deux qui sont :
- la polarisation à 0° et la polarisation orthogonale à 90°, d'une part, et
- la polarisation à 45° et la polarisation orthogonale à 135°, d'autre part.

Ce routeur optique élémentaire a un format 2×2, et comprend deux routeurs optiques binaires qui ont chacun un format 2×1, lesdits routeurs optiques binaires étant alignés en colonne suivant la direction Y.

On considérera aussi, ensuite et en référence aux schémas de la **FIG.7A** à la **FIG.7D**, un autre exemple encore d'un routeur optique élémentaire, qui est adapté pour trier en sortie la lumière incidente reçue en entrée en fonction de sa polarisation parmi six états de polarisation croisés deux-à-deux, qui sont :
- la polarisation linéaire à 0° et la polarisation linéaire orthogonale à 90°,
- la polarisation linéaire à 45° et la polarisation linéaire orthogonale à 135°, et enfin,
- la polarisation circulaire gauche (CL) et la polarisation circulaire droite (CR).

Ce routeur optique élémentaire a un format 2×3. Il comprend trois routeurs optiques binaires qui sont chacun de format 2×1, lesdits trois routeurs optiques binaires étant alignés en colonne suivant la direction Y.

De manière plus générale, chaque routeur optique élémentaire est de format N×M, où N et M sont des nombres entiers supérieurs à l'unité (≥1) et dont l'un au moins est strictement supérieur à l'unité (>1). Dans les exemples représentés dans les figures des dessins, N est le nombre de zones de sorties du motif de routage unitaire qui sont agencées côte-à-côte le long de la direction X et ce nombre est strictement supérieur à l'unité (N > 1), alors que M est le nombre de ses zones de sorties qui sont agencées côte-à-côte le long de la direction Y et ce nombre est supérieur ou égal à l'unité (M ≥ 1). Mais l'inverse est bien entendu possible également, c'est-à-dire qu'on peut prévoir que N est supérieur ou égal à l'unité (N ≥ 1), alors que M est strictement supérieur à l'unité (M > 1).

Dans tous les cas, les N×M sorties optiques d'un routeur élémentaire comprennent des couples de zones de sortie duales de routage sélectif de la lumière. Pour un routeur optique en polarisation de la lumière, ces zones de sortie duales sont adaptées pour séparer *a minima* deux états de polarisation croisés parmi des couples d'états de polarisation croisés, *i.e.,* des couples de polarisations croisées. Dit autrement, à chaque couple d'états de polarisation croisés à séparer correspond un routeur optique binaire ayant un couple de zones de sortie optique couplées à des pixels respectifs qui sont dédiés chacun à la détection de l'un de ces deux états de polarisation.

Par exemple, et de préférence, des routeurs optiques binaires différents d'un routeur optique élémentaire, adapté chacun pour séparer des couples d'états de polarisation déterminés dans la lumière incidente, peuvent être disposés adjacents deux-à-deux suivant une direction différente de la direction de routage optique telle que définie plus haut, laquelle est commune à tous les routeurs optiques binaires. Ainsi, si la direction de routage optique est la direction X, alors les routeurs optiques binaires de format 2×1 du routeur optique élémentaire de format N×M (avec N>1) peuvent être disposés en étant adjacents deux-à-deux suivant la direction Y ou, *vice versa,* si la direction de routage est la direction Y, alors les routeurs optiques binaires de format 1×2 du routeur optique élémentaire N×M (avec M>1) peuvent être disposés en étant adjacents deux-à-deux suivant la direction X.

Dans une variante, les routeurs optiques binaires du routeur optique élémentaire peuvent être disposés en étant adjacents deux-à-deux suivant la direction de routage de la lumière au sein des routeurs binaires. Cette configuration alternative est possible mais elle est toutefois non idéale. En effet, conformément aux modes de réalisation qui seront explicités plus loin en référence à des exemples, deux routeurs optiques élémentaires sont disposés en sorte d'être adjacents suivant la direction de routage de la lumière, et en miroir l'un de l'autre suivant ladite direction, au sein d'une cellule de routage optique plus grande que l'on appelle un "routeur optique de base". L'effet technique recherché par cette disposition particulière des deux routeurs élémentaires ainsi disposés tête-bêche suivant la direction de routage au sein du routeur de base, risque d'être moins bien obtenu, voire pas obtenu du tout avec la variante ci-dessus.

Dans le dispositif de routage optique de la lumière, un "routeur optique de base" est l'unité de routage optique qui est répétée spatialement (ou répliquée) suivant la direction X et/ou suivant la direction Y pour couvrir tout ou partie de la matrice de photodétecteurs (pixels). Ces routeurs de base sont disposés au-dessus de la matrice de photodétecteurs. Ils présentent chacun un motif de routage de base identique. Conformément aux modes de réalisation, ce motif de routage de base est symétrique selon la direction X et/ou selon la direction Y. A cet effet, il comprend deux routeurs optiques élémentaire adjacents suivant la direction X qui sont disposés en miroir l'un de l'autre suivant ladite direction, et/ou deux routeurs optiques élémentaire adjacents suivant la direction Y qui sont disposés en miroir l'un de l'autre suivant ladite direction.

Par ailleurs, on désigne par "motif de routage de base" la configuration spatiale (appréciée dans le plan de la surface sensible du détecteur optoélectronique, qui est parallèle au plan horizontal (X,Y) dans les exemples représentés aux figures), des sorties optiques du routeur de base. La personne du métier appréciera que, par extension de ce qui a été dit plus haut à propos d'un routeur élémentaire et d'un routeur binaire en particulier, il s'agit aussi, corrélativement, de la configuration spatiale de leurs pixels associés dans la matrice de photodétecteurs sous-jacente. Cette configuration spatiale est adaptée pour trier la lumière en sortie du routeur de base (on peut se représenter que cela consiste à générer au niveau des zones de sortie optique du routeur des pseudo "sous-flux" lumineux distincts), en discriminant des valeurs respectives distinctes d'un des paramètres optiques, *i.e.,* la polarisation ou la longueur d'onde dans les exemples considérés ici, de la lumière qui est reçue en entrée du routeur de base.

Un routeur optique de base est donc un routeur optique à motif de routage de base qui est symétrique suivant au moins l'une des directions X et Y, cette symétrie provenant du fait que ledit routeur de base comprend deux routeurs optiques élémentaires à motif élémentaire de format N×M qui sont disposés de manière contigüe en alignement suivant ladite direction (laquelle est de préférence la direction de routage optique, à savoir la direction X dans les dessins), et dont l'un est l'image (ou réflexion) de l'autre par une symétrie orthogonale par rapport à un plan P de l'espace euclidien de dimension 3 qui est orthogonal à ladite direction d'alignement, appelée symétrie ou réflexion de plan P.

En mathématiques, dans l'espace affine euclidien de dimension 3, une réflexion est une symétrie orthogonale par rapport à un plan orthogonal à un axe d'observation. Un élément est le symétrique d'un autre élément lorsqu'il est l'image dudit autre élément par une transformation qui est une symétrie par rapport à un plan P orthogonal à un axe joignant les deux éléments. L'origine du terme se conçoit bien en liaison avec les miroirs qui réfléchissent une image. En effet, le premier routeur et le second routeur sont images l'un de l'autre par une transformation qui est une symétrie par rapport à un plan P orthogonal à la direction X suivant laquelle ils sont alignés. C'est pourquoi on dira aussi que le second routeur est disposé "en miroir" du premier routeur suivant la direction X. Un élément est dit symétrique, lorsqu'il est l'image de lui-même par une symétrie.

Un motif de routage unidirectionnellement symétrisé est donc un motif symétrique de format 2N×M ou N×2M, qui présente une symétrie suivant une unique direction déterminée parmi les directions X et Y du fait de l'agencement de deux routeurs élémentaires en miroir l'un de l'autre suivant ladite direction. Dans l'exemple montré à la FIG.4B, cette direction unique est la direction X, si bien que le routeur est symétrique suivant l'axe X. On parlera dans ce qui suit d'une symétrie unidirectionnelle suivant la direction X, qui correspond à la direction suivant laquelle cette symétrie est observée. Pour le motif de routage unidirectionellement symétrisé présente donc une symétrie suivant la direction X, qui est avantageusement la direction d'alignement des routeurs. On appellera motif de routage bidirectionnellement symétrisé, de façon similaire, un motif symétrique de format 2N×2M, qui présente une symétrie suivant à la fois la direction X et la direction Y, du fait de la disposition de couples de routeurs élémentaires en miroir l'un de l'autre à la fois suivant la direction X et suivant la direction Y.

En d'autres termes, et pour résumer, un routeur optique binaire est un routeur à deux sorties optiques, *i.e.,* à un couple de zones de sortie optique, alors qu'un un routeur optique élémentaire est un routeur à deux sorties optiques ou plus, *i.e.,* un routeur optique ayant un groupe de Q zones de sortie, où Q est un nombre entier supérieur à 2. Un routeur élémentaire peut donc être un routeur binaire, dans le cas particulier où Q est égal à 2 (Q=2). Une pluralité de fonctions de tri sont simultanément et conjointement réalisées, au sein d'un seul et même routeur optique élémentaire réunissant plusieurs routeurs optiques binaires, par routage de la lumière en sortie pour générer des couples de pseudo "sous-flux" lumineux séparés qui sont respectivement détectés par des couples de pixels associés distincts. Cette pluralité de fonctions de tri découle de la pluralité de couples d'états de polarisation qui sont discriminés, chacun par l'un des différents routeurs optiques binaires. Dit autrement, on peut se représenter un routeur élémentaire comme un routeur ayant une unique entrée optique définie par sa surface supérieure, et une ou plusieurs paires de sorties optiques qui sont les deux sorties optiques respectives d'autant de routeurs optiques binaires distincts compris, le cas échéant, dans ledit routeur optique élémentaire.

Par ailleurs, un routeur optique de base comprend deux routeurs élémentaires adjacents, qui sont disposés en miroir l'un de l'autre, suivant l'une et/ou l'autre des directions X et Y qui définissent le plan de la surface sensible de la matrice de pixels, et de préférence suivant en particulier la direction du routage optique. Le motif de base d'un routeur optique de base est symétrique suivant la direction d'alignement des deux routeurs élémentaires du routeur de base correspondant. Des routeurs de base, qui sont tous identiques, sont dupliqués, en étant adjacents deux-à-deux, suivant la direction X et/ou suivant la direction Y, pour couvrir tout ou partie de la surface sensible du détecteur optoélectronique. On dit à ce sujet que le motif de base des routeurs de base est répété spatialement suivant la direction X et/ou suivant la direction Y.

La personne du métier appréciera que le format d'un routeur élémentaire est de préférence le plus régulier possible, c'est à dire que N et M sont des nombres le plus proche possible l'un de l'autre. Le cas idéal est celui d'un routeur élémentaire régulier, pour lequel N est égal à M (N=M), le motif de routage de format N×M étant alors carré. En effet, les routeurs élémentaires ont vocation à être spatialement répétés à la fois suivant la direction X et suivant la direction Y afin de couvrir la surface sensible de la matrice de photodétecteurs. Pour une question d'homogénéité de la répartition des zones de sortie optique du dispositif de routage optique qui sont dédiées à la détection des différents états de polarisation ou des différentes longueurs d'onde de la lumière incidente, il est donc préférable d'éviter qu'un routeur optique élémentaire présente un format très irrégulier (c'est à dire avec N très supérieur, ou très inférieur à M).

Dans un exemple, la différence entre N et M est au plus égale à quatre (*i.e.,* |N-M| ≤ 4), de manière préférée inférieure à trois (*i.e.,* [N-M| ≤ 3), et de manière encore plus préférée inférieur ou égale à deux (*i.e.,* |N-M| ≤ 2).

En référence au schéma simplifié de la **FIG.2** et, en outre, dans le cas des exemples introduits brièvement ci-dessus et qui seront explicités plus loin, on a considéré uniquement le routage optique en fonction de la polarisation de la lumière.

Cependant, il est bien entendu qu'un routeur optique élémentaire, *i.e.,* un routeur optique à une entrée optique et à N×M sorties optiques, peut aussi être utilisé lorsque le dispositif de routage optique est un dispositif de routage optique en longueur d'onde de la lumière. Ainsi par exemple, un routeur optique binaire en longueur d'onde comprend deux zones de sortie optique au niveau desquelles la lumière incidente reçue en entrée du routeur est triée sur la base de deux longueurs d'onde distinctes qui sont présentes, le cas échéant, dans ladite lumière incidente. Les cas d'usage dans lesquels on cherche à trier la lumière en fonction de deux longueurs d'onde seulement semblent *a priori* être peu nombreux en pratique, mais rien n'empêche d'appliquer l'enseignement technique divulgué dans la présente description à des routeurs optiques binaires destinés à un tel cas d'usage.

Lorsqu'on cherche à trier la lumière dans un dispositif photo-électronique en fonction de la longueur d'onde, toutefois, c'est généralement pour séparer la détection des trois couleurs classiquement considérées en optoélectronique, à savoir le rouge (R), le vert (V) et le bleu (B). C'est pourquoi un routeur optique élémentaire en longueur d'onde sera généralement un routeur optique à une entrée optique et au moins trois sorties optiques associées chacune à un pixel de la matrice de photodétecteurs. Souvent, et pour des raisons de topologie de réalisation des dispositifs de photodétection à deux dimensions (2D), le motif de routage du routeur optique élémentaire en longueur d'onde sera un motif carré de format 2×2. Un tel routeur optique élémentaire possède une entrée optique et quatre sorties optiques associées chacune à un pixel de la matrice de photodétecteurs sous-jacente, et deux zones de sortie optique diamétralement opposées sont dédiées à la détection de la même couleur parmi le rouge, le vert et le bleu. De la sorte, l'une des couleurs est utilisée deux fois plus que chacune des deux autres. Ceci n'est pas sans rappeler le motif élémentaire d'une matrice de filtration de couleurs (ou CFA, de l'anglais "*Color Filter Array*") ou matrice de Bayer qui est une matrice de filtrage de type RVB (Rouge-Vert-Bleu) de format 2×2 appliquée sur les photodétecteurs d'un capteur couleur en technologie CMOS. Dans une telle matrice de filtrage, c'est le vert qui est utilisé deux fois plus que le rouge et le bleu afin de rapprocher le capteur couleur de la vision de l'œil humain qui voit mieux dans le vert que dans le rouge ou le bleu. Mais la ressemblance s'arrête à cette seule observation, puisque tant structurellement que fonctionnellement un filtre coloré à motif de Bayer est sans rapport avec un routeur optique en longueur d'onde.

On décrira plus loin, en référence aux schémas de la **FIG.8A** à la **FIG.8C****,** un exemple non limitatif d'un routeur optique élémentaire en longueur d'onde, qui est adapté pour trier en sortie la lumière incidente reçue en entrée en fonction de sa longueur d'onde parmi trois couleurs distinctes, qui sont, le rouge, le vert et le bleu. Ce routeur optique élémentaire a un motif de routage de format 2×2.

La personne de métier appréciera que, quelque que soit le type de routage optique réalisé, la distinction entre les deux zones de sortie optique de chaque couple ou groupe de zones de sortie optique du motif de routage élémentaire de la lumière, concerne en pratique les caractéristiques optiques (en termes de polarisation ou de longueur d'onde) des flux de lumière respectivement délivrés par ces zones de sortie optique après que le flux de lumière incidente a traversé ledit routeur optique correspondant. Dit autrement, l'effet sélectif du routage optique en polarisation ou en longueur d'onde se traduit par des caractéristiques hétérogènes des pseudo "sous-flux" lumineux sortant des différentes zones de sortie optique au niveau de la face inférieure du routeur optique considéré, *i.e.,* en-dessous dudit routeur optique. Ces caractéristiques sont spécifiques pour chaque zone de sortie optique, par rapport aux caractéristiques spatialement homogènes du flux lumineux unique reçu par la zone d'entrée optique au niveau de la face supérieure du routeur optique, *i.e.,* par le dessus dudit routeur optique. En effet, la distribution de la lumière en sortie du routeur optique est modifiée du fait de son passage à travers la nanostructure de la méta-surface formant le routeur optique, par rapport à ce qu'elle est en entrée. Ceci sera explicité en détail, plus loin, en référence au schéma de la **FIG.3B****.**

On notera que le dispositif de routage peut avantageusement être disposé directement au-dessus de la matrice de photodétecteurs, de sorte que la séparation spatiale de la lumière en fonction des états de polarisation ou la séparation spatiale de la lumière en fonction des longueurs d'onde de la lumière a lieu directement au niveau de la surface sensible du capteur optoélectronique, au niveau pixel.

L'axe de routage optique, ou les axes de routage optiques le cas échéant, c'est-à-dire la direction X et/ou la direction Y suivant laquelle la déviation de la lumière a lieu, est particulièrement sensible au phénomène de couplage réciproque ("*crosstalk*"). C'est pourquoi on cherche surtout à éviter le couplage réciproque dans cet axe-là.

On va maintenant décrire différents modes de réalisation du dispositif de routage optique de la lumière en polarisation ou en longueur d'onde. Différents exemples de motifs de routage élémentaires sont explicités, notamment pour réaliser différents types de routage sélectif de la lumière *(i.e.,* en fonction de différents paramètres de la lumière incidente : états de polarisation ou longueurs d'onde), et/ou ayant des formats N×M différents, dont certains qui peuvent comprendre plusieurs motifs de routage binaires combinés.

Le premier exemple donné ci-dessous sera détaillé afin d'exposer les effets techniques et avantages obtenus grâce à ce mode de réalisation. La personne du métier sera à même d'extrapoler, à partir de cet exposé relativement plus détaillé, les effets techniques et avantages pouvant être obtenus grâce aux autres modes de réalisation qui seront décrits ensuite plus succinctement.

### Routeur en polarisation, motif format 2×1

La **FIG.3A** montre schématiquement, en vue de dessus, un motif de routage élémentaire 30' pour le routage optique en polarisation de la lumière. Il s'agit d'un motif de routage binaire, de format 2×1. Le motif de routage binaire 30' comprend deux zones de sortie optique distinctes qui sont alignées suivant l'une des directions X et Y, à savoir la direction X dans l'exemple non limitatif tel que représenté. Ces zones de sortie optique sont :
- une première zone de sortie optique 31 qui est adaptée pour délivrer en sortie la portion d'une lumière incidente ayant une polarisation déterminée, par exemple la polarisation linéaire à 0° ; et,
- une seconde zone de sortie optique 32 qui est adaptée pour délivrer en sortie la portion de lumière ayant une polarisation linéaire orthogonale, à 90° dans cet exemple.

Le schéma de la **FIG.3B** montre, en coupe verticale, un détecteur optoélectronique 40 très simplifié, comme par exemple un capteur d'image en technologie CMOS. Le dispositif 40 comprend une matrice de photodétecteurs 41 avec au moins deux pixels 35 et 36 similaires aux pixels 25 et 26 présentés plus haut en référence à la FIG.2, qui sont adjacents suivant la direction X. Le dispositif 40 comprend aussi un dispositif 42 de routage optique en polarisation de la lumière, formé directement au-dessus de la matrice de photodétecteurs 41. Le dispositif de routage optique 42 peut recevoir en entrée un flux de lumière 10, lequel est symbolisé, comme à la figure 2, par la série de flèches verticales noires orientées du haut vers le bas pour figurer une lumière incidente sous incidence normale, c'est-à-dire perpendiculaire à la surface supérieure du détecteur 40. Le dispositif 42 comprend en outre un routeur optique élémentaire 30, qui est en l'occurrence un routeur optique binaire en polarisation de la lumière ayant le motif de routage montré à la FIG.3A. Ce routeur optique 30 comprend les deux zones de sortie optique 31 et 32, qui sont directement au-dessus des pixels 35 et 36, respectivement, de la matrice de photodétecteurs 41 sous-jacente.

Comme déjà indiqué plus haut, la distinction entre les deux zones de sortie optique 31 et 32 du motif de routage 30' concerne en pratique les caractéristiques (en termes de polarisation, dans cet exemple) de la lumière en sortie du routeur optique binaire 30, *i.e.,* en-dessous dudit routeur après que la lumière incidente arrivant en entrée, *i.e.,* par le dessus du routeur optique 30 a traversé ledit routeur en subissant une déviation sélective. En effet, la distribution spatiale de la lumière en sortie du routeur *(i.e.,* directement en-dessous du routeur 30, au niveau des zones de sortie optique 31 et 32 dans la configuration telle qu'illustrée) est modifiée du fait de la nanostructure de la méta-surface que réalise le motif de routage binaire 30, par rapport à ce qu'elle est en entrée *(i.e.,* au-dessus du routeur dans la configuration telle qu'illustrée).

Le routeur optique binaire 30 est adapté pour trier en sortie, c'est-à-dire au niveau de la surface inférieure dudit routeur, le flux de lumière incidente 10 en fonction de l'état de polarisation de la lumière. Plus spécifiquement, la lumière incidente 10 est séparée en deux pseudo "sous-flux" optiques, symbolisés par les flèches verticales épaisses noires 11 et 12 au niveau des zones de sortie optique 31 et 32, respectivement. Les caractéristiques optiques respectives du flux de lumière incidente 10 en entrée et des deux "sous-flux" optiques délivrés par les sorties optiques 11 et 12, se distinguent substantiellement par la polarisation de la lumière :
- le flux de lumière incidente 10 en entrée est essentiellement homogène en termes de polarisation de la lumière, en ce sens que les états de polarisation à 0° et à 90° y sont mélangés ; alors que,
- le flux de lumière global en sortie est substantiellement inhomogène en termes de polarisation de la lumière, comme étant formé :
   - d'un premier "sous-flux" de lumière de sortie, délivré par la zone de sortie optique 11 et qui comprend l'essentiel la lumière incidente ayant une polarisation déterminée (à savoir la polarisation linéaire à 0° dans l'exemple) et qui est orienté vers la surface sensible d'un premier pixel déterminé à savoir le pixel de gauche 35 dans l'exemple ; ainsi que
   - d'un second "sous-flux" de lumière de sortie, délivré par la zone de sortie optique 12 et qui comprend l'essentiel la lumière incidente ayant une polarisation orthogonale (et plus particulièrement la polarisation linéaire à 90° dans l'exemple) et qui est orienté vers la surface sensible d'un autre pixel à savoir le pixel de droite 36 dans l'exemple.

Le motif de routage binaire 30' du routeur optique 30 en polarisation de la lumière est par exemple réalisé sous la forme d'une méta-surface spécialement adaptée pour le routage en polarisation de la lumière suivant la direction X, c'est-à-dire la déviation sélective de la lumière suivant ladite direction X, en fonction de son état de polarisation parmi les deux états de polarisation linéaire orthogonaux, à 0° et à 90°, respectivement. Dans l'exemple montré, cette direction X est, en effet, la direction suivant laquelle les zones de sortie optique 31 et 32 du motif de routage binaire 30 sont alignées, côte-à-côte. Dit autrement, le motif de routage binaire 30 comprend les deux zones de sortie optique 31 et 32 disposées de manière adjacente et contigüe suivant la direction X, et ces zones de sortie optique délivrent chacune, respectivement, la portion de la lumière ayant une polarisation linéaire déterminée à savoir la polarisation à 0° et la portion de la lumière ayant une polarisation linéaire orthogonale à savoir la polarisation à 90°.

Fonctionnellement, les deux zones de sortie optique 31 et 32 du motif de base 30 sont respectivement associées chacune à l'un des deux photodétecteurs (pixels) 35 et 36 qui sont disposés en-dessous desdites zones, comme. Ces pixels 35 et 36 ont idéalement des dimensions dans le plan (X,Y) qui correspondent à celles des zones de sortie optique 31 et 32, respectivement, suivant à la fois suivant la direction X et suivant la direction Y. Comme il est illustré à la **FIG.3B****,** la zone de sortie optique 31 et la zone de sortie optique 32 du routeur binaire 30 dévient la lumière incidente, selon que sa polarisation est à 0° ou 90°, soit vers le pixel 35 soit vers le pixel 36, respectivement. En fonctionnement, les photodiodes des pixels 35 et 36 produisent des flux d'électrons respectifs, c'est-à-dire des courants de détection optoélectronique respectifs, qui sont fonction du nombre de photons qui ont été déviés par le routeur optique 30 à partir de la lumière incidente 10, c'est-à-dire qui dépendent de l'intensité lumineuse de la lumière polarisée linéairement à 0° pour le pixel 35, et de la lumière polarisée linéairement à 90° pour le pixel 36, respectivement.

En résumé, dans le détecteur optoélectronique 40, chacune des zones de sortie optique 31 et 32 du motif de base 30' du routeur optique 30 est associée, au sens défini au paragraphe précédent, à un photodétecteur respectif dudit détecteur 40, à savoir une paire de pixels comprenant le pixel 35 et le pixel 36 dans l'exemple considéré. Et ces pixels 35 et 36 sont disposés suivant le même agencement, au format N×M et en l'occurrence au format 2×1, que les zones de sortie optique 31 et 32 du motif de routage binaire 30' du routeur optique en polarisation de la lumière 30. En outre, chacune des zones de sortie optique 31 et 32 du motif de base 30' a des propriétés respectives de routage de la lumière pour un état de polarisation linéaire déterminé, à savoir 0° et 90° dans cet exemple. Il va sans dire que, dans une variante, le motif 2×1 de ces figures pourrait tout aussi bien être conçu pour dévier sélectivement la lumière selon deux autres types de polarisation linéaires croisées, comme par exemple en fonction des états de polarisation linéaire orthogonaux à 45° et à 135°, respectivement. De même, dans une autre variante le motif 2×1 de la FIG.3A et de la FIG.3B pourrait également être conçu pour dévier sélectivement la lumière selon les états de polarisation circulaire droite (CR) et de polarisation circulaire gauche (CL), respectivement.

En référence à la **FIG.3C****,** une nanostructure de routage en polarisation de la lumière classique peut comprendre un agencement de routeurs optiques élémentaires 30 formé de la répétition spatiale (ou réplication), un nombre K1 déterminé de fois suivant une direction déterminée, ici par exemple la direction X, du motif du routage binaire 30 de la FIG.3A. Les K1 motifs de routage binaire 30 ainsi alignés suivant la direction X sont contigus deux-à-deux. Dit autrement, ils ne sont pas espacés suivant ladite direction X. La direction X est de préférence la direction de routage de la lumière, cette direction étant déterminée par la taille et la répartition spatiale des nano-piliers de la méta-surface qui réalise le motif du routage binaire 30 avec les zones de sortie optique 31 et 32. Le nombre K1 est sensiblement égal au rapport de la dimension de la surface sensible du détecteur optoélectronique suivant la direction d'alignement X, sur la dimension du motif de routage binaire 30 suivant ladite direction X. Par exemple, en considérant que la longueur L1 suivant la direction X de chacun des deux pixels 35 et 36 qui sont disposés sous les zones 31 et 32 du motif de routage en polarisation 30 (cf. FIG.2) est sensiblement égale à 4 µm, et que la longueur de la surface sensible du détecteur optique suivant ladite direction X est sensiblement égale à 5 mm, alors le nombre K1 est sensiblement égal à 625 (K1=625), étant donné que 5 mm / (2×4 µm) = 625.

La **FIG.3D** est une représentation schématique en vue de-dessous qui est semblable à celle de la FIG.3C montrant le routeur optique 30 qui a été décrit dans ce qui précède. Mais cette nouvelle figure montre cette fois un dispositif de routage optique en polarisation de la lumière conforme à des modes de réalisation proposés pour réduire le couplage réciproque entre les paires de pixels qui sont adjacents deux-à-deux suivant la direction X du routage optique. Selon ces modes de réalisation, le dispositif de routage comprend toujours un agencement formé de la répétition spatiale d'un routeur optique de base 30x suivant la même direction de routage qu'à la FIG.3B, c'est-à-dire la direction X dans cet exemple. Mais cet agencement comprend ici la réplication, un nombre K2 de fois, d'un motif de routage de base 30x', qui diffère du motif de routage de base 30' du routeur de base 30 de la FIG.3C. Ce nouveau motif de routage de base 30x'est symétrisé suivant la direction X, et possède un format de type 4×1. On dit de ce motif de routage de base 30x' qu'il est symétrisé suivant la direction X en ce sens qu'il combine, alignés de manière contigüe suivant ladite direction X :
- un premier motif de routage binaire 30a correspondant au motif de routage binaire 30' de la FIG.3A ; et,
- un second motif de routage optique binaire 30b qui est une version "en miroir", suivant la direction d'alignement X, dudit motif de routage binaire 30' de la FIG.3A.

Comme on l'aura compris, dans cet exemple le nombre K2 correspond à la moitié de K1 (K2=K1/2). Le second motif de routage optique binaire 30b est disposé "en miroir" du premier motif de routage optique binaire 30a suivant la direction X en ce sens que le motif de routage 30b est l'image (ou la réflexion) du motif de routage 30a, et *vice versa,* par une symétrie orthogonale par rapport à un plan P de l'espace euclidien de dimension 3, qui est orthogonal à la direction X d'alignement de ces deux motifs de routage 30a et 30b adjacents. Cette relation euclidienne est appelée symétrie ou réflexion de plan P.

La combinaison des motifs de routage 30a et 30b ainsi agencés côte-à-côte et "tête-bêche" suivant la direction X, forme un motif de base 30x' qui est répété spatialement, à l'identique, pour couvrir tout ou partie de la surface sensible du détecteur photoélectrique suivant la direction X. Le motif de routage de base 30x' est de format 4×1. Il est dit "symétrique suivant la direction X" car il est l'image de lui-même par la symétrie de plan P précitée, ledit plan P étant le plan orthogonal à la direction d'alignement X des routeurs élémentaires 30a et 30b qui est situé entre lesdits routeurs élémentaires.

En pratique, dans un dispositif de routage optique en polarisation de la lumière selon le présent mode de réalisation, on réplique des routeurs optiques de base 30x ayant le motif de routage de base 30x' de format 4×1 présenté ci-dessus, suivant également l'autre direction Y du plan [X,Y] de la surface sensible du détecteur optoélectronique incorporant le dispositif, pour former un maillage à deux dimensions couvrant au moins une partie, et idéalement l'intégralité de cette surface sensible. Cette réplication du routeur de base suivant la direction Y n'est pas visible à la FIG.3D, laquelle n'illustre la réplication du routeur optique de base 30x symétrisé que suivant la direction de routage X, afin de ne pas surcharger cette figure.

La personne de métier appréciera que le routeur optique élémentaire 30 de la FIG.3B ayant un motif de routage 30' de format 2×1, le routeur optique de base 30x de la figure 3D qui est un routeur optique symétrisé obtenu par l'agencement de deux tels routeurs adjacents disposés en miroir l'un de l'autre suivant la direction X, a un motif de routage de base symétrisé 30x' qui est de format 4×1. Mais, de manière plus générale, si le routeur optique élémentaire a un motif de routage de format N×M, alors le routeur optique de base a un motif de routage de base symétrisé de format 2N×M dans le cas d'une symétrisation unidirectionnelle suivant l'axe X comme représenté. Il peut aussi être de format N×2M en cas de symétrisation unidirectionnelle suivant l'axe Y, et de format 2N×2M en cas de symétrisation bidirectionnelle suivant à la fois l'axe X et l'axe Y.

On va maintenant expliciter, en comparant la **FIG.4A** et la **FIG.4B****,** comment la symétrie du motif de routage de base 30x' du routeur optique de base symétrisé 30x qui est illustré à la FIG.3D permet de réduire le couplage réciproque (ou couplage croisé) entre pixels adjacents dans un dispositif de routage optique en polarisation de la lumière, par rapport au motif de routage de base 30' du routeur optique de base 30 de la FIG.3C. On rappelle que, dans l'exemple non limitatif de ces figures, on ne considère pour simplifier qu'une seule direction de routage optique, et qu'une seule direction de réplication du motif de routage de base, qui dans les deux cas est la direction X. La personne du métier saura généraliser cet exposé au cas d'une réplication du motif de routage de base suivant à la fois la direction X et la direction Y.

La **FIG.4A** est un schéma simplifié, en coupe verticale, d'un détecteur optoélectronique 40 comprenant une matrice de photodétecteurs 41 d'une part, et, au-dessus de ladite matrice 41, un dispositif de routage optique en polarisation de la lumière 42, d'autre part. Le dispositif 42 comprend un agencement classique de routeurs élémentaires identiques, à savoir des routeurs binaires 30 conformes à la FIG.3C qui sont répétés spatialement pour couvrir une partie de la surface sensible de la matrice de photodétecteurs 41, en étant alignés suivant au moins une direction donnée, à savoir ici la direction X.

Si l'on considère uniquement le pseudo "sous-flux" lumineux qui comprend la partie de la lumière incidente 10 qui présente l'état de polarisation à 90°, on constate qu'une partie essentielle seulement de ce "sous-flux", représentée par la flèche épaisse verticale dirigée du haut vers le bas, est orientée vers le pixel situé en dessous de la zone de sortie optique correspondante du motif de routage 30', lequel pixel est celui qui est dédié à la détection de la lumière incidente polarisée à 90° (à savoir le pixel de droite dans l'exemple). Mais une petite partie de ce "sous-flux" est orientée vers un pixel voisin suivant la direction de routage X, *i.e.,* côté gauche à la figure 4A, et une autre petite partie de ce "sous-flux" est orientée vers l'autre pixel voisin suivant ladite direction X, *i.e.,* côté droit à la figure 4A, par l'effet du phénomène inhérent de couplage croisé. Ces deux parties minoritaires respectives du "sous-flux" de la lumière incidente 10 qui comprennent de la lumière à l'état de polarisation à 90°, sont représentées par des flèches en trait moins épais, qui sont orientées en travers vers la gauche et en travers vers la droite, respectivement, à la FIG.4A. Or, ces deux pixels voisins, à gauche et à droite, sont dédiés à la détection de l'état de polarisation croisé, c'est-à-dire à la détection de la lumière incidente polarisée à 0° dans l'exemple. Dit autrement, les photons minoritaires du "sous-flux" de lumière polarisée à 90° qui sont déviés vers le pixel de gauche et vers le pixel de droite, sont perdus pour la détection par le pixel du centre qui est dédié à la détection de la lumière ayant cette polarisation. Par ailleurs, ces photons polluent la détection de la lumière polarisée à la polarisation croisée, *i.e.,* à la polarisation à 0° dans les deux pixels voisins qui sont dédiés à la détection de ladite polarisation croisée.

La personne de métier appréciera qu'en raison du même phénomène de couplage réciproque entre pixels adjacents, une partie minoritaire des photons à l'état de polarisation à 0° ne sont pas orientés vers un pixel de la matrice de photodétecteurs 41 qui est dédié à la détection de cette polarisation, mais sont orientés dans l'un et dans l'autre des pixels adjacents suivant la direction X qui sont dédiés à la détection de la polarisation croisée, *i.e.*, à la détection de la polarisation à 90° dans l'exemple. Ce phénomène n'est pas figuré à la FIG.4A. En outre, il va sans dire que, dans le cas d'un détecteur optoélectronique ayant un dispositif de routage optique de la lumière avec un motif de routage de base qui est répété spatialement suivant, à la fois, les deux directions X et Y, le même phénomène de couplage réciproque entre pixels adjacents se produit aussi, simultanément, entre des pixels qui sont adjacents suivant l'autre direction, à savoir la direction Y dans l'exemple.

Comme on le comprend, le couplage réciproque entre pixels adjacents diminue sensiblement le PER de chacun des pixels de la matrice de photodétecteurs du détecteur optoélectronique 40.

La **FIG.4B** est un schéma simplifié, en coupe verticale, d'un détecteur optoélectronique 40" comprenant une matrice de photodétecteurs 41" et, au-dessus de ladite matrice 41", un dispositif de routage optique en polarisation de la lumière 42" conforme à la FIG.3D. Cette figure illustre la réplication, en alignement suivant la direction X et de manière contigüe deux-à-deux suivant ladite direction, d'une pluralité de routeurs de base 30x qui sont symétrisés, précisément, suivant cette direction d'alignement X laquelle est aussi la direction du routage optique dans les routeurs élémentaires (routeurs binaires ici). Il s'agit ici de routeurs optiques de base ayant le motif de routage de base 30x' de format 4×1 déjà représenté à la FIG.3A. Cette réplication consiste à répéter spatialement, suivant la direction X en l'occurrence, le motif de routage de base symétrisé 30x' pour couvrir au moins en partie la surface sensible de la matrice de photodétecteurs 41'. A la FIG.4B, on voit un seul routeur optique de base 30x en entier, et la moitié d'un autre routeur optique de base 30x sur la droite, suivant la direction X.

Conformément à l'enseignement de l'invention, le phénomène de couplage réciproque entre pixels adjacents qui a été explicité ci-dessus en référence à la FIG.4A, fait ici qu'une partie de la lumière polarisée à 90° qui est délivrée par la zone de sortie optique mais n'est pas orientée vers le pixel sous-jacent qui est dédié à la détection de la lumière avec cette polarisation, se retrouve malgré tout atteindre un pixel adjacent qui est dédié à la détection de ladite polarisation. Ce résultat est obtenu en raison du fait que, grâce à la mise en miroir de deux routeurs optiques élémentaires 30a et 30b (voir FIG.3D) suivant la direction X pour former le routeur de base 30x avec un motif de routage de base 30x' qui est symétrique suivant ladite direction X, deux pixels dédiés à la détection de la lumière à un même état de polarisation, se retrouve adjacents l'un de l'autre. Ainsi, en référence à la FIG.4B, une partie du "sous-flux" lumineux figurée par les flèches étroites qui figurent une partie de la lumière incidente 10 qui est dans l'état de polarisation à 90° est orientée vers un pixel adjacent qui est dédié à la détection de ladite polarisation.

Selon la solution proposée, on dispose les routeurs élémentaires de telle manière que deux routeurs élémentaires adjacents soient disposés en miroir l'un de l'autre suivant la direction X. En d'autres termes, chacun de ces deux routeurs est le reflet de l'autre par rapport à un plan de symétrie qui est un plan orthogonal à la direction X d'alignement des routeurs, au niveau de leur séparation (*i.e.,* à leur limite commune séparative) suivant ladite direction. On obtient de cette manière un placement induit de paires de pixels dédiés à la détection de la lumière à une polarisation donnée, par lequel ces pixels sont disposés côte-à-côte suivant la direction X d'alignement de deux routeurs élémentaires au sein du routeur de base.

Ainsi, même en cas de couplage réciproque entre pixels, une partie (environ la moitié) de la lumière ayant une polarisation déterminée et qui est déviée au-delà du pixel vers lequel elle est routée par un routeur élémentaire 30a ou 30b, illuminera quand même un pixel adjacent qui est également dédié à la détection de la lumière ayant cette polarisation. Le PER sera donc moins dégradé grâce à cet agencement.

La personne du métier appréciera que même si l'alignement et la disposition en miroir de routeurs élémentaires adjacents uniquement suivant la direction X est considérée dans ce qui précède, le format du motif élémentaire d'un routeur élémentaire et l'agencement des routeurs élémentaires peut être transposé à l'autre direction définissant, avec ladite direction X, le plan [X,Y] de la surface sensible du détecteur optique, à savoir la direction Y dans l'exemple. Le format du motif de routage élémentaire 30' des routeurs élémentaires 30 considérés est alors un format 1×2 au lieu d'un format 2×1 et, corollairement, les paires de pixels associés sont des pixels adjacents suivant l'autre direction Y du plan [X,Y] de la surface sensible du détecteur optique.

En résumé, l'agencement des routeurs élémentaires qui est proposé, permet de diminuer l'effet du couplage réciproque ("*crosstalk*") entre pixels adjacents et, ainsi, d'améliorer le PER. En mirrorant le motif élémentaire 30 dans le motif de base 30x ainsi symétrisé, le couplage réciproque sera moins impactant sur le PER. On ne peut certes pas s'affranchir du couplage réciproque dans les pixels adjacents à la fois de part et d'autre (latéralement) d'un pixel considéré, mais l'impact du couplage réciproque sur le PER est quand même significativement réduit. Cette mise en miroir produit un effet technique qui est propre à la solution au problème technique consistant à réduire les inconvénients du couplage optique réciproque entre pixels adjacents tout bénéficiant des avantages du routage optique, par rapport au filtrage optique, en relation avec la sensibilité du détecteur optoélectronique, comme exposé en introduction.

Un autre intérêt du motif de routage de base symétrisé concerne le design de la phase. En effet, même si l'intention première est de diminuer l'impact du couplage réciproque entre pixels adjacents, il est observé que le fait de répéter spatialement des routeurs de base ayant un motif de routage de base symétrique supprime aussi les sauts de phase de la lumière le long de la direction d'alignement desdits routeurs à l'interface entre des routeurs de base adjacents.

En effet, lorsque les routeurs optiques de base formés par la juxtaposition suivant la direction de routage X de deux routeurs binaires en polarisation qui sont mis en miroir l'un de l'autre le long de cette direction sont créés avec des méta-surfaces, ces méta-surfaces reproduisent des fronts d'onde différents pour les deux polarisations orthogonales. Ces fronts d'onde sont illustrés par les courbes de la **FIG.5A** pour le routeur optique 30 dont le motif de routage de base est donné à la FIG.3A, qui comprend les deux pixels 35 et 36 de la FIG.3B qui sont adjacents suivant la direction de routage X. La FIG.5A indique, en abscisses, la position spatiale le long de la direction de routage X, pour une portion de la surface du détecteur optoélectronique au niveau des deux pixels 35 et 36. La phase de la lumière, entre la valeur 0 et la valeur 2π, est représentée en ordonnées. Les traits verticaux en pointillés réguliers sont les limites des pixels, et les traits verticaux en pointillés longs et courts alternés désignent les centres des pixels 35 et 36. Une méta-surface de base recouvre un pixel comme le pixel de gauche 35 dédié à la détection de la polarisation à 0°, ainsi qu'un pixel comme le pixel de droite 36 dédié à la détection de la polarisation à 90°.

Plus particulièrement la courbe 51 donne l'évolution de la phase Φₚ₀ de la lumière ayant la polarisation p0 qui est la polarisation linéaire à 0°, et la courbe 52 donne l'évolution de la phase Φₚ₉₀ de la lumière ayant la polarisation p90 qui est la polarisation linéaire orthogonale à 90°, en fonction de la position suivant la direction de routage X le long de la portion considérée du détecteur, c'est-à-dire au niveau des deux pixels 35 et 36. Les profils de phase sont des profils sphériques. Dans cet exemple le front d'onde 51 doit faire converger la lumière polarisée à 0° dans le pixel de gauche 35, alors que le front d'onde 52 doit faire converger la lumière polarisée à 90° dans le pixel de droite 36. La personne du métier appréciera que les courbes de phase 51 et 52 illustrent l'évolution de la phase des composantes électrique et magnétique de la lumière, suivant la direction X du routage optique en polarisation de la lumière dans le détecteur optique.

Lorsqu'on répète le motif de routage de base 30' en alignant des routeurs optiques 30 identiques sur une portion au moins de la longueur du capteur optoélectronique suivant la direction X, cela crée des discontinuités de phase selon ladite direction X. Une telle discontinuité de phase est illustrée par la référence 55 sur les courbes 51 et 52 de la **FIG.5B** pour deux routeurs alignés suivant la direction X sans la mise en œuvre de l'invention. Dit autrement, lorsque les profils de phase du motif de base sont répliqués suivant la direction X, un saut de phase apparait à la frontière entre 2 méta-surfaces contigües suivant ladite direction X. De telles discontinuités de phase peuvent être néfastes pour l'efficacité du routage optique.

Lorsqu'on utilise le motif de routage de base symétrisé par la mise en miroir de deux routeurs élémentaires adjacents suivant la direction de routage X, les sauts de phase sont réduits voire supprimés, ainsi que montré par la référence 55x sur les courbes 51x et 52x de la **FIG.5C**, qui correspondent aux courbes 51 et 52, respectivement, de la **FIG.5A** et de la **FIG.5B****.** De plus, cela permet d'éviter les conflits en bordures de méta-surfaces. Typiquement en effet, on utilise des nano-piliers qui ont la charge de modifier la phase comme souhaité. Or, les nano-piliers placés en bordure des portions de méta-surface associés aux pixels sous-jacents posent en général problème car, en référence aux courbes 51 et 52 de la FIG.5A, ils doivent fournir une phase de 0° pour le pixel de gauche 35 mais une phase de 90° pour le pixel de droite 36. Il y a ainsi localement une incompatibilité. Le motif en miroir permet de lever le conflit et de mutualiser les nano-piliers placés en bordure des portions de méta-surface associés aux pixels sous-jacents 35 et 35 pour la génération des deux phases à 0° et à 90°, respectivement.

En résumé, dans les profils de phase 51' et 52' du motif de routage de base formé de deux motifs de routage binaires agencés en miroir l'un de l'autre suivant la direction X, le saut de phase 55 visible à la FIG.5B est supprimé, ce qui permet de mutualiser le nano-pilier à la frontière entre les deux méta-surfaces correspondantes, qui sont adjacentes suivant ladite direction X.

Le principe de l'invention a été testé en simulation simplifiée puis en simulation complète sur un pixel réel, par exemple un pixel Fox^{™} de la société STMicroelectronics^{®}.

Les simulations dites "simplifiées" comprennent uniquement la méta-surface et le piédestal. Les performances en PER sont calculées par l'intégrale du module du champ électrique au carré en bas du piédestal (à la surface supérieure du pixel, mais sans le simuler).

Les simulations dites "complètes" comprennent en plus la simulation de la propagation optique dans un pixel CMOS entièrement modélisé, *i.e.,* avec la modélisation de la photodiode, des niveaux de métallisation, des tranchées d'isolation étroites (ou STI, de l'anglais *"Shallow Trench Isolation*")*,* etc. Le PER est calculé par le pourcentage de lumière absorbée dans la photodiode, comme exposé plus haut. Ce sont des simulations uniquement optiques et pas électriques, mais on fait l'hypothèse que le nombre de photons qui sont absorbés par la photodiode est proportionnel au nombre d'électrons qui sont générés.

En simulation simplifiée, on a simulé la méta-surface de 5.22 µm×2.61 µm sur un piédestal en SiO2 seule, et on a relevé l'intensité optique (énergie absorbée) dans les parties droite et gauche d'un routeur binaire ainsi simulé. On observe un gain de +15% sur le pixel de gauche 35 et un gain de +6% sur le pixel droit 36, avec un routeur optique de base avec un motif de routage de base 30x' symétrisé par rapport à un routeur optique de base avec un motif de routage de base 30' non symétrisé, comme reflété par les données du tableau ci-dessous.

**[Table 1]**

| | PER pixel gauche | | PER pixel droit | |
|---|---|---|---|---|
| Motif de base non symétrisé | | 3.55 | | 4.12 |
| Motif de base symétrisé | | 4.12 | | 4.39 |

En simulation complète, on a placé la méta-surface sur un pixel Fox^{™} de la société STMicroelectronics^{®} de 2.61 µm (soit une méta-surface de 5.22µm×2.61µm) et on a relevé l'énergie absorbée par la photodiode en silicium. Là encore, on obtient un gain d'environ 15% sur le pixel gauche et d'environ 34% sur le pixel droit, comme reflété par les données du tableau ci-dessous.

**[Table 2]**

| | PER pixel gauche | PER pixel droit |
|---|---|---|
| Motif de base non symétrisé | 1.86 | 1.775 |
| Motif de base symétrisé | 2.13 | 2.38 |

Il apparaît donc que les améliorations de PER constatées en simulation simplifiée proviennent de la suppression du saut de phase qui est obtenue grâce à la mise en œuvre de l'invention : la phase devient continue et la méta-surface fonctionne mieux optiquement.

Les améliorations du PER constatées en simulation complète proviennent quant à elles à la fois de la suppression du saut de phase (*cf* ci-dessus) et de l'atténuation du couplage réciproque entre pixels adjacents qui est due au fait que la moitié du "*cross talk*" de la polarisation à 0° tombe quand même dans un pixel dédié à la détection de la polarisation à 0°, au lieu de tomber dans un pixel dédié à la détection de la polarisation à 90°).

### Routeur en polarisation, motif format 2×2

Si plusieurs couples différents d'états de polarisation doivent être discriminés par routage dans une application particulière considérée, on peut définir un routeur optique élémentaire formé de la combinaison d'autant de routeurs binaires respectifs qui partagent la même entrée optique. Par exemple, les dessins de la **FIG.6A** à la **FIG.6C** illustrent un routeur élémentaire en polarisation 60 comprenant deux routeurs binaires adaptés pour séparer en sortie, deux couples d'états de polarisation croisés présents dans la lumière incidente. Il s'agit en l'occurrence de deux polarisations linéaires orthogonales entre elles, à savoir dans cet exemple :
- les états de polarisation linéaire à 0° et à 90° ; et,
- les états de polarisation linéaire à 45° et à 135°.

Dans l'exemple non limitatif montré sur les dessins de la **FIG.6A****,** le motif de routage élémentaire 60' du routeur binaire est formé de la juxtaposition, suivant la direction Y, de deux motifs de routage binaires 60-1 et 60-2, respectivement. Ces deux motifs de routage binaires sont respectivement adaptés pour séparer des états de polarisation linéaire orthogonale à 0° et à 90°, d'une part, et les états de polarisation linéaire orthogonale à 45° et à 135°, d'autre part. Le motif binaire 60-1 comprend à cet effet deux zones de sortie optiques 61 et 62, qui sont adjacentes suivant la direction X qui est la direction de routage optique en polarisation de la lumière. Le motif binaire 60-2 comprend également deux zones de sortie optiques 63 et 64, qui sont adjacentes suivant la direction X. Les motifs de routage binaires 60-1 et 60-2 sont des motifs de format 2×1.

Le motif de routage élémentaire 60' est un exemple de motif de routage régulier, c'est-à-dire de format N×M avec N=M. Cet exemple non limitatif est un motif de routage otique quaternaire, c'est-à-dire un motif de routage à quatre sorties optiques qui sont les zones de sortie optiques 61, 62, 63 et 64. C'est un motif de routage carré, c'est-à-dire de format 2×2 avec quatre zones de sortie optique disposées en carré (c'est-à-dire, aussi, sur deux lignes et sur deux colonnes). Bien entendu, un motif de routage régulier (*i.e.,* un motif de routage dont les zones de sortie optique sont agencées en carré) selon l'invention n'entend être limité ni par le nombre des zones de sortie optiques ni par les valeurs spécifiques d'états de polarisation croisés indiqués ci-dessus, qui ne sont donnés qu'à titre purement exemplatif et non-limitatif.

La **FIG.6B** montre partiellement, en vue de dessus, un dispositif de routage en polarisation de la lumière comprenant un agencement de routeurs élémentaires 60 formé en répétant spatialement le motif du routage de format 2×2 de la FIG.6A suivant au moins une direction déterminée, qui est de préférence la direction de routage X. Dans l'exemple représenté, les routeurs élémentaires 60 ayant tous le même motif de routage élémentaire 60' sont les routeurs optiques de base qui sont répliqués pour couvrir une partie au moins de la surface sensible du détecteur optoélectronique. Dans l'exemple montré, les routeurs optiques de base 60 sont répétés spatialement à la fois suivant la direction X et suivant la direction Y qui définissent le plan de la surface sensible dudit détecteur optoélectronique. La personne de métier appréciera que, dans le dispositif de routage optique en polarisation de la lumière de la FIG.6B, aucun pixel associé à une zone de sortie optique des motifs de routage des routeurs optiques juxtaposés suivant la direction X et suivant la direction Y, n'est contigu à un autre pixel dédié à la détection de la lumière avec la même polarisation que lui-même. Le couplage réciproque entre pixels adjacents suivant la direction X ou suivant la direction Y impacte pleinement le PER de chacun des pixels.

La **FIG.6C** montre partiellement, en vue de dessus, un dispositif de routage en polarisation de la lumière comprenant, comme celui montré à la FIG.6B, un agencement de routeurs de base 60x formé en répétant spatialement de tels routeurs de base à la fois suivant la direction X et suivant la direction Y. Toutefois, conformément à des modes de réalisation de l'invention, le routeur de base 60x comprend deux routeurs quaternaires 60a et 60b comme le routeur quaternaire 60 de la FIG.6A, mais disposés l'un à côté de l'autre et en miroir l'un de l'autre suivant une direction déterminée, qui est de préférence la direction de routage X. Le motif de routage de base 60x' de ce routeur de base 60x comprend donc huit zones de sortie optique, et est de format 4×2. La mise en miroir des deux routeurs quaternaires 60a et 60b suivant la direction X donne au routeur optique de base 60x une symétrie suivant la direction X. Dit autrement, le routeur optique de base 60x est symétrique suivant la direction X. On dit qu'il est unilatéralement symétrisé, puisqu'il n'est symétrique que suivant l'une seulement des deux directions X et Y.

En comparant les schémas de la **FIG.6A** et de la **FIG.6C****,** on constate que dans le dispositif de routage de la FIG.6C, un routeur optique de base 60x comprend des zones de sortie optiques associées à des pixels adjacents dédiés à la détection de la lumière ayant la même polarisation, qui sont contigus suivant la direction X : il s'agit dans l'exemple représenté des zones de sortie optique délivrant la lumière polarisée à 90° et des zones de sortie optique délivrant la lumière polarisée à 135°. En outre, le dispositif de routage de la FIG.6C comprend d'autres paires de pixels adjacents dédiés à la détection de la lumière ayant la même polarisation qui sont contigus suivant la direction X : il s'agit dans l'exemple représenté des zones de sortie optique délivrant la lumière polarisée à 0° et des zones de sortie optique délivrant la lumière polarisée à 45° qui sont sur les bordures respectives contigües de deux routeurs optiques symétrisés 60x adjacents suivant la direction X. Ces contiguïtés entre zones de sortie optique associées à des pixels dédiés à la détection de la lumière ayant la même polarisation, est procurée par la symétrie des routeurs optiques de base 60x qui sont dupliqués suivant ladite direction X. Ces contiguïtés améliorent le PER en atténuant l'effet du couplage réciproque inhérent entre pixels adjacents suivant la direction X.

La **FIG.6D** montre partiellement, en vue de dessus, un dispositif de routage en polarisation de la lumière comprenant, comme celui montré à la FIG.6B et celui de la FIG.6C, un agencement de routeurs de base 60xy formé en répétant spatialement de tels routeurs de base à la fois suivant la direction X et suivant la direction Y (pour des raisons d'espace, un seul routeur de base 60xy est représenté, mais des points de suspension figurent la répétition spatiale de ce routeur de base suivant la direction X et suivant la direction Y). Conformément à d'autres modes de réalisation de l'invention, le routeur de base 60xy comprend quatre routeurs élémentaires quaternaires 60a, 60b, 60c et 60d comme le routeur élémentaire quaternaire 60 de la FIG.6A, mais disposés en étant adjacents deux-à-deux et en miroir deux-à-deux à la fois suivant la direction de routage X et suivant la direction perpendiculaire Y. Le motif de routage de base 60xy' de ce routeur de base 60xy comprend donc seize zones de sortie optique associés à seize pixels respectifs de la matrice de pixels du détecteur. Ce motif de routage est de format 4×4. La mise en miroir des quatre routeurs élémentaires quaternaires 60a, 60b, 60c et 60d suivant la direction X et suivant la direction Y donne au routeur optique de base 60xy une symétrie suivant chacune des deux directions X et Y. Dit autrement, le routeur optique de base 60xy est symétrique à la fois suivant la direction X et suivant la direction Y. On dit qu'il est bilatéralement symétrisé, puisqu'il est symétrique à la fois suivant chacune des deux directions X et Y.

En comparant le schéma de la **FIG.6D** avec celui de la **FIG.6C****,** on constate que dans le routeur 60xy de la FIG.6D le nombre de zones de sortie optique du motif de routage de base bilatéralement symétrisé 60xy' qui sont associées à des pixels dédiés à la détection de la lumière avec une même polarisation et qui sont contigües suivant la direction X et/ou la direction Y au sein dudit motif de routage de base symétrisé 60xy', est augmenté de manière très significative par rapport au motif de routage de base 60x' unilatéralement symétrisé de la FIG.6C. Bien sûr, ce nombre est encore plus augmenté par rapport au motif de routage de base non symétrisé 60' de la FIG.6B.

En effet, chaque pixel du dispositif de détection optoélectronique selon la FIG.6D est contigu avec au moins un autre pixel dédié à la détection de la lumière ayant la même polarisation que lui-même, au sein des pixels associés aux zones de sortie optique du motif de routage de base symétrisé 60xy' (sauf les zones de sortie optique aux quatre coins dudit motifs, dont les pixels associés sont dédiés à la détection de la polarisation linéaire à 45° dans l'exemple représenté).

Mieux encore, on constate en extrapolant la répétition du motif de routage de base 60xy' symétrique à la fois suivant la direction X et suivant la direction Y, que chaque pixel du dispositif de détection optoélectronique sera contigu avec au moins un autre pixel dédié à la détection de la lumière ayant la même polarisation que lui-même. Ce résultat optimal provient du fait que le motif de routage élémentaire 60' est régulier, *i.e.,* du fait qu'il est un motif ayant un format carré, de type 2×2 dans cet exemple. Toutes ces contiguïtés améliorent le PER en atténuant l'effet du couplage réciproque inhérent entre pixels adjacents suivant la direction X et suivant la direction Y.

### Routeur en polarisation, motif format 2×3

Comme déjà annoncé dans ce qui précède, les schémas de la **FIG.7A** à la **FIG.7D** illustrent un autre exemple de routeur optique élémentaire 70, qui est adapté pour trier en sortie la lumière incidente reçue en entrée en fonction de sa polarisation parmi six états de polarisation croisés deux-à-deux, qui sont :
- la polarisation linéaire à 0° et la polarisation linéaire orthogonale à 90°,
- la polarisation linéaire à 45° et la polarisation linéaire orthogonale à 135°, et enfin,
- la polarisation circulaire gauche (CL) et la polarisation circulaire droite (CR).

La **FIG.7A** montre de façon schématique, en vue de-dessus, un tel motif de routage élémentaire sénaire de format 2×3, qui peut être réalisé par une méta-surface similaire à celle de la FIG.2, pour être utilisé dans le dispositif de routage optique en polarisation d'un détecteur optoélectronique. Ce routeur optique sénaire 70 présente un motif de routage 70' irrégulier, de format 2×3. Il comprend en effet trois routeurs optiques binaires 70-1, 70-2 et 70-3 qui ont chacun un motif de routage binaire de format 2×1, lesdits trois routeurs optiques binaires étant alignés en colonne suivant la direction Y. Le motif de routage binaire du routeur optique binaires 70-1 possède deux zones de sortie optique 71 et 72, adjacentes suivant la direction X. De même, le motif de routage binaire du routeur optique binaires 70-2 possède deux zones de sortie optique 73 et 74, adjacentes suivant la direction X. De même enfin, le motif de routage binaire du routeur optique binaires 70-3 possède deux zones de sortie optique 75 et 76, adjacentes suivant la direction X.

Les motifs de routage binaires ci-dessus des routeurs binaires 70-1, 70-2 et 70-3, sont respectivement adaptés pour séparer chacun un couple d'états de polarisation croisés de la lumière différent. Il peut s'agir en particulier de deux polarisations linéaires orthogonales entre elles et/ou des deux polarisations circulaires, à savoir dans un exemple :
- les états de polarisation linéaire à 0° et à 90°, pour le routeur binaire 70-1, respectivement ;
- les états de polarisation linéaire à 45° et à 135°, pour le routeur binaire 70-2 ; et/ou,
- les états de polarisation circulaire droite (ou CR) et de polarisation circulaire gauche (ou CL) , pour le routeur binaire 70-3.

Le motif de routage élémentaire 70' est un exemple de motif de routage irrégulier, c'est-à-dire de format N×M avec N≠M. Cet exemple non limitatif est un motif de routage otique sénaire, c'est-à-dire un motif de routage à six sorties optiques qui sont les zones de sortie optiques 71 à 76. C'est un motif de routage rectangulaire, c'est-à-dire avec un nombre égal à N×M de zones de sortie optique disposées sur M lignes et sur N colonnes. Bien entendu, un motif de routage irrégulier *(i.e.,* un motif de routage dont les zones de sortie optique sont agencées en rectangle) selon l'invention n'entend être limité ni par le nombre des zones de sortie optiques ni par les valeurs spécifiques d'états de polarisation croisés indiqués ci-dessus, qui ne sont donnés qu'à titre purement exemplatif et non-limitatif.

Le schéma de la **FIG.7B** montre partiellement, en vue de dessus, un dispositif de routage en polarisation de la lumière comprenant un agencement de routeurs élémentaires formé de la répétition spatiale du motif de routage de format 2×3 de la FIG.7A à la fois suivant la direction X et suivant la direction perpendiculaire Y. Comme représenté, les routeurs élémentaires 70 ont tous le même motif de routage élémentaire 70'. Ils sont répliqués de façon bidirectionnelle pour couvrir une partie au moins de la surface sensible du détecteur optoélectronique. La personne de métier appréciera que, dans le dispositif de routage optique en polarisation de la lumière de la FIG.7B, aucun pixel associé à une zone de sortie optique des motifs de routage 70' des routeurs optiques 70 juxtaposés suivant la direction X et suivant la direction Y, n'est contigu à un autre pixel dédié à la détection de la lumière avec la même polarisation que lui-même. Le couplage réciproque entre pixels adjacents suivant la direction X ou suivant la direction Y impacte pleinement le PER de chacun des pixels.

Le schéma de la **FIG.7C** montre partiellement, en vue de dessus, un dispositif de routage en polarisation de la lumière comprenant, comme celui montré à la FIG.7B, un agencement de routeurs de base 70x formé en répétant spatialement de tels routeurs de base à la fois suivant la direction X et suivant la direction Y. Toutefois, conformément à des modes de réalisation de l'invention, ce routeur de base 70x comprend deux routeurs sénaires 70a et 70b comme le routeur sénaire 70 de la FIG.7A, mais disposés l'un à côté de l'autre et en miroir l'un de l'autre suivant une direction déterminée, qui est de préférence la direction de routage X. Le motif de routage de base 70x' de ce routeur de base 70x comprend donc douze zones de sortie optique, et est de format 4×3. La mise en miroir des deux routeurs sénaires 70a et 70b suivant la direction X donne au routeur optique de base 70x une symétrie suivant la direction X. Dit autrement, le routeur optique de base 70x est symétrique suivant la direction X, étant unilatéralement symétrisé suivant l'une seulement des deux directions X et Y.

Enfin, le schéma de la **FIG.7D** montre partiellement, en vue de dessus, un dispositif de routage en polarisation de la lumière comprenant, comme celui montré à la FIG.7B et celui de la FIG.7C, un agencement de routeurs de base 70xy formé en répétant spatialement de tels routeurs de base à la fois suivant la direction X et suivant la direction Y (là encore, pour des raisons d'espace dans les dessins, un seul routeur de base 70xy est visible à la FIG.7D). Toutefois, conformément à d'autres modes de réalisation de l'invention, le routeur de base 70xy comprend quatre routeurs élémentaires quaternaires 70a, 70b, 70c et 70d comme le routeur élémentaire sénaire 60 de la FIG.7A, mais disposés en étant adjacents deux-à-deux et en miroir deux-à-deux à la fois suivant à la direction de routage X et suivant la direction perpendiculaire Y. Le motif de routage de base 70xy' de ce routeur de base 70xy comprend donc vingt-quatre zones de sortie optique associées à vingt-quatre pixels respectifs de la matrice de pixels du détecteur. Ce motif de routage est de format 4×6. La mise en miroir des quatre routeurs élémentaires sénaires 70a, 70b, 70c et 70d suivant la direction X et suivant la direction Y donne au routeur optique de base 70xy une symétrie suivant chacune des deux directions X et Y. Dit autrement, le routeur optique de base 70xy est bilatéralement symétrisé, étant symétrique à la fois suivant la direction X et suivant la direction Y.

En comparant le schéma de la **FIG.7C** avec celui de la **FIG.7B****,** et en comparant le schéma le schéma de la **FIG.7D** avec celui de la **FIG.7C** et avec celui de la **FIG.7B****,** on relève les mêmes avantages concernant l'atténuation de l'effet du couplage réciproque entre pixels adjacents dans la matrice de photodétecteurs, que ceux qui ont été relevés plus haut en comparant les schémas de la FIG.6D, de la FIG.6C, et de la FIG.6D.

La personne de métier notera, toutefois, que dans le dispositif de la FIG.7D chaque pixel est contigu, suivant la direction X et/ou suivant la direction Y, à un autre pixel dédié à la détection de la lumière avec la même polarisation que lui-même, mais que contrairement au cas de la FIG.6D, tous les pixels ne sont pas contigus, à la fois suivant la direction X et suivant la direction Y, un tel autre pixel. Ceci est dû au fait que le motif de routage élémentaire 70' du routeur optique élémentaire 70 de la FIG.7A n'est pas régulier. Ce motif est rectangulaire de format 2×3, c'est-à-dire de format N×M avec N différent de M (N≠M). Il demeure que l'effet du couplage réciproque entre pixels adjacents est substantiellement atténué par rapport à un dispositif de routage optique dont le motif de routage de base n'est pas symétrisé conformément aux modes de réalisation de la FIG.7C et de la FIG.7D.

### Routeur en longueur d'onde, motif format 2×2

Une autre caractéristique optique sur la base de laquelle la lumière peut être sélectivement routée est la longueur d'onde. L'enseignement technique de la présente divulgation s'applique aussi au routage optique en fonction de la longueur d'onde de la lumière, *i.e.,* à des routeurs optiques dont le motif de routage possède au moins deux zones de sortie optique qui sont associées chacune à une longueur d'onde déterminée, par exemple une longueur parmi les longueurs d'onde correspondant aux couleurs rouge, vert et bleu, respectivement.

La **FIG.8A** est une représentation schématique, en vue de dessus, d'un motif de routage en longueur d'onde 80' de format 2×2 d'un dispositif de routage optique 80 pouvant aussi être réalisé par une méta-surface dans un détecteur optique similaire à celui de la FIG.2. Selon cet exemple, le routeur optique en longueur d'onde 80 présente un motif de routage élémentaire quaternaire 80'de format 2×2, c'est-à-dire un motif de routage élémentaire à une entrée optique et quatre sorties optiques disposées en carré. Ces quatre zones de sortie optique 81, 82, 83 et 84 sont arrangées sur deux lignes s'étendant suivant la direction X et deux colonnes s'étendant suivant la direction Y.

Les zones de sortie optique du motif de routage 80' comprennent :
- une zone de sortie optique 81 qui est couplée de manière opérationnelle à un pixel de la matrice de photodétecteurs sous-jacente qui est dédié à la détection de la lumière à la longueur d'onde correspondant à la couleur rouge,
- deux autres zones de sortie optique 82 et 83 qui sont mutuellement opposées diamétralement, et qui sont respectivement couplées de manière opérationnelle à deux pixels de la matrice de photodétecteurs sous-jacente dédiés ensemble à la détection de la lumière à la longueur d'onde correspondant à la couleur verte,
- une autre zone de sortie optique encore, *i.e.,* la quatrième et dernière zone de sortie optique 84 du motif de routage quaternaire, qui est couplée de manière opérationnelle à un pixel de la matrice de photodétecteurs sous-jacente qui est dédié à la détection de la lumière à la longueur d'onde correspondant à la couleur bleue.

La personne de métier appréciera que, en ce qui concerne uniquement l'aspect relatif à la disposition spatiale, le motif de routage quaternaire 80' est semblable à un motif de filtrage de Bayer classiquement utilisé pour filtrer la lumière en longueur d'onde dans les capteurs d'image en technologie CMOS. On pourra en particulier considérer le motif XTrans^{™} de la société FUJIFILM divulgué dans le document WO2023275032A1 et qui a été mentionné en introduction. C'est pourquoi, et par analogie, le motif de routage 80' du routeur optique en longueur d'onde 80 de la FIG.8A peut être vu comme, et appelé un motif de routage en longueur d'onde "du type d'un motif de Bayer R-V-V-B".

Le motif de routage élémentaire 80' est un exemple de motif de routage en longueur d'onde régulier, c'est-à-dire de format N×M avec N=M. Cet exemple non limitatif est un motif de routage otique quaternaire, c'est-à-dire un motif de routage à quatre sorties optiques qui sont les zones de sortie optiques 81, 82, 83 et 84, mais adapté pour trier la lumière en fonction d'un nombre moindre de longueur d'onde différentes, à savoir trois longueurs d'onde dans cet exemple. Il s'ensuit, comme déjà évoqué, que deux des quatre zones de sortie optique sont couplées à des pixels dédiés à la détection de la même longueur d'onde (en l'occurrence la longueur d'onde du vert, dans l'exemple considéré). C'est un motif de routage carré, c'est-à-dire de format 2×2 avec quatre zones de sortie optique disposées en carré (sur deux lignes et sur deux colonnes). Bien entendu, un motif de routage en longueur d'onde n'est pas forcément un motif régulier *(i.e.,* un motif de routage dont les zones de sortie optique sont agencées en carré). Il peut aussi s'agir d'un motif de routage irrégulier, dont les zones de sortie optique sont agencées en rectangle. Plus généralement, il va sans dire qu'un dispositif de routage optique en longueur d'onde selon des modes de réalisation de l'invention n'est limité ni par le nombre ou l'agencement spatial des zones de sortie optique ni par les valeurs spécifiques des longueurs d'onde indiqués ci-dessus, de l'exemple de motif de routage en longueur d'onde 80' qui ne sont donnés qu'à titre purement exemplatif et non-limitatif.

La **FIG.8B** est une représentation schématique, en vue de dessus, d'un dispositif de routage en longueur d'onde de la lumière comprenant un agencement de routeurs élémentaires 80 formé de la répétition contigüe du motif de routage 2×2 de la FIG.8A suivant à la fois la direction X et suivant la direction perpendiculaire Y, sans la mise en œuvre de la symétrisation conforme à des modes de réalisation de l'invention.

On appréciera que, dans le dispositif de routage optique en longueur d'onde de la lumière de la FIG.8B, aucun pixel associé à une zone de sortie optique des motifs de routage 80' des routeurs optiques 80 juxtaposés suivant la direction X et suivant la direction Y, n'est contigu à un autre pixel dédié à la détection de la lumière avec la même longueur d'onde que lui-même. Le couplage réciproque entre pixels adjacents suivant la direction X ou suivant la direction Y impacte pleinement le PER de chacun des pixels.

La **FIG.8C** est une représentation schématique, en vue de dessus, d'un dispositif de routage optique en longueur d'onde de la lumière comprenant un agencement formé de la répétition spatiale de routeurs optiques de base 80xy, dont le de motif de routage de base 80xy est de format 4×4 (pour des raisons d'espace sur la figure, là encore un seul routeur de base 80xy est représenté, mais des points de suspension figurent la répétition spatiale de ce routeur de base suivant la direction X et suivant la direction Y). Le dispositif comprend des couples de routeurs élémentaires (quaternaires) 80a, 80b, 80c et 80d identiques au routeur élémentaire 80 de la FIG.8A mais qui sont mis deux-à-deux en miroir l'un de l'autre, à la fois suivant la direction X et suivant la direction perpendiculaire Y conformément à des modes de réalisation de l'invention. Le motif de routage de base 80xy' du routeur optique de base ainsi obtenu comprend seize zones de sortie optiques, associées à seize pixels respectifs de la matrice de pixels sous-jacente. Et il est symétrisé bidirectionnellement, c'est-à-dire à la fois suivant la direction X et suivant la direction perpendiculaire Y. En effet, la mise en miroir des quatre routeurs élémentaires quaternaires 80a, 80b, 80c et 80d suivant la direction X et suivant la direction Y donne au routeur optique de base 80xy une symétrie suivant chacune des deux directions X et Y. Dit autrement, le routeur optique de base 60xy est symétrique à la fois suivant la direction X et suivant la direction Y.

En comparant le schéma de la **FIG.8C** avec celui de la **FIG.8B****,** on constate que dans le routeur 80xy de la FIG.8C il existe des zones de sortie optique du motif de routage de base bilatéralement symétrisé 80xy' qui sont associées à des pixels dédiés à la détection de la lumière à une même longueur d'onde, et qui sont contigües suivant la direction X et/ou la direction Y au sein dudit motif de routage de base symétrisé 80xy'.

Avantageusement, chaque pixel du dispositif de détection optoélectronique selon la FIG.8C est contigu avec au moins un autre pixel dédié à la détection de la lumière ayant la même longueur d'onde que lui-même (sauf les pixels associés aux zones de sortie optique aux quatre coins du motif de base 80xy, dont les pixels associés sont dédiés à la détection de longueur d'onde correspondant au vert dans l'exemple représenté).

On constate en outre, en extrapolant la répétition du motif de routage de base 80xy' symétrique à la fois suivant la direction X et suivant la direction Y, que chaque pixel du dispositif de détection optoélectronique sera contigu avec au moins un autre pixel dédié à la détection de la lumière ayant la même polarisation que lui-même. Ce résultat optimal provient là aussi, comme pour le routeur de base 80xy montré à la FIG.8D, du fait que le motif de routage élémentaire 80' est régulier, *i.e.,* du fait qu'il est un motif ayant un format carré, de type 2×2 dans cet exemple.

Toutes ces contiguïtés améliorent le PER en atténuant l'effet du couplage réciproque inhérent entre pixels adjacents suivant la direction X et suivant la direction Y.

L'exemple de routeur optique en longueur d'onde considéré ci-dessus en référence à la **FIG.8A****,** à la **FIG.8B****,** et à la **FIG.8C** donne également l'occasion de généraliser ici la notion de direction du routage optique de la lumière dans un routeur optique élémentaire.

Jusqu'ici en effet, il n'a été considéré, dans chaque exemple de routeur optique donné dans la présente description et représenté sur les figures des dessins, uniquement le cas d'une unique direction de routage de la lumière au sein du routeur optique élémentaire d'un dispositif de routage optique de la lumière. Ceci vient de ce que les différents modes de réalisation présentés jusqu'ici concernent des routeurs optiques élémentaires formés à partir d'un ou plusieurs routeurs optiques binaires, combinés le cas échéant en étant alignés suivant la direction perpendiculaire à la direction de routage de la lumière. Or, dans un routeur optique binaire, les règles de routage de la lumière sont toujours les mêmes, et sont également binaires pour chaque routeur binaire composant le routeur optique élémentaire : la lumière qui n'a pas la caractéristique optique (polarisation ou longueur d'onde) à la détection de laquelle l'un déterminé des deux pixels associés aux deux zones de sortie optique respectives est dédié, est déviée de manière à s'éloigner de la zone de sortie optique associée à ce pixel, et à être orientée en direction du centre de la zone de sortie optique associée à l'autre pixel, et réciproquement. Ceci n'est toutefois pas limitatif des modes de réalisation possible de l'invention. En effet, et notamment dans le cas d'un routeur optique en longueur d'onde, tout autre plan de routage peut comprendre des règles de routage optique plus sophistiquées, en fonction des particularités propres à chaque application, et en fonction notamment du tri (*i.e.,* de la discrimination) à obtenir en sortie du routeur entre les différentes longueurs d'onde considérées, ainsi qu'en fonction du nombre de pixels disponibles c'est-à-dire, aussi, en fonction du nombre de zones de sorties optiques disponibles pour effectuer ce tri.

La **FIG.9A****, la** **FIG.9B** et la **FIG.9C** sont des représentations schématiques illustrant différentes règles de routage optiques envisageables du plan de routage de la lumière dans le motif de routage en longueur d'onde 2×2 de la FIG.8A, lequel est représenté en vue de dessus sur ces figures. Ces différentes règles de routage en longueur d'onde de la lumière concernent toutes la même configuration spatiale des quatre zones de sortie optique 81, 82, 83 et 84. Elles s'appliquent aux trois longueurs d'onde qui sont triées par le routeur optique 80, à savoir le vert, le rouge et le bleu, respectivement. En ce sens, on peut dire que la FIG.9A, la FIG.9B, et la FIG.9C illustrent les règles de routage de la lumière incidente à la longueur d'onde du vert, à la longueur d'onde du rouge et à la longueur d'onde du bleu, respectivement.

Dans la FIG.9A, la FIG.9B, et la FIG.9C, des flèches épaisses blanches figurent la direction et le sens de la déviation de la lumière qui est causée par la méta-surface qui réalise le routeur élémentaire 80, dans chacun des cas pour la lumière verte, pour la lumière rouge et pour la lumière bleue, respectivement. Ainsi, dans ces exemples :
- à la FIG.9A : la lumière incidente à la longueur d'onde du vert est déviée de manière à s'éloigner de la zone de sortie optique 81 qui est associée à un pixel dédié à la détection du rouge ainsi qu'à s'éloigner de la zone de sortie optique 84 qui est associée à un pixel dédié à la détection du bleu, pour être orientée vers les zones de sortie optique 82 et 83 qui sont associées à des pixels dédiés à la détection du vert, comme il est figuré par les flèches épaisses blanches sur cette figure ;
- à la FIG.9B : la lumière incidente à la longueur d'onde du rouge est déviée de manière à s'éloigner de la zone de sortie optique 82 et de la zone de sortie optique 83 qui sont associées à des pixels dédiés à la détection du vert, ainsi qu'à s'éloigner de la zone de sortie optique 84 qui est associée à un pixel dédié à la détection du bleu, pour être orientée vers la zones de sortie optique 81 qui est associée à un pixel dédié à la détection du rouge, comme il est figuré par les flèches épaisses blanches sur cette figure ; et, enfin
- à la FIG.9C : la lumière incidente à la longueur d'onde du bleu est déviée de manière à s'éloigner de la zone de sortie optique 82 et de la zone de sortie optique 83 qui sont associées à des pixels dédiés à la détection du vert, ainsi qu'à s'éloigner de la zone de sortie optique 81 qui est associée à un pixel dédié à la détection du rouge, pour être orientée vers la zone de sortie optique 84 qui est associée à un pixel dédié à la détection du bleu, comme il est figuré par les flèches épaisses blanches sur cette figure.

La personne de métier appréciera que le principe de symétrisation du motif de routage de base reste compatible avec chacun des plans de routage parmi ceux décrits ci-dessus en référence aux schémas de la FIG.9A, la FIG.9B et la FIG.9C, ainsi que d'autres encore, notamment dans le cas de routeurs optiques en longueur d'onde ayant une autre topologie que celle du routeur 80 illustré à la FIG.8A. En effet, dès lors que la mise en miroir de deux routeurs optique élémentaires est effectuée suivant la direction X et/ou suivant la direction Y crée une contiguïté spatiale entre deux pixels adjacents qui sont dédiés à la détection de la lumière avec la même caractéristique optique (à savoir la longueur d'onde dans ces exemples non limitatifs), l'effet du couplage réciproque entre pixels adjacents qui est inhérent à toute matrice de photodétecteurs est atténué, et le PER des pixels concernés est amélioré.

Les règles de routage optique de la lumière aux différentes longueurs d'onde de la FIG.9A, la FIG.9B et la FIG.9C illustrent aussi pourquoi il serait erroné de limiter les modes de réalisation en considérant que les routeurs optiques élémentaires mis en miroir l'un de l'autre dans un routeur optique de base symétrisé devraient être disposés côte-à-côte suivant « la » direction de routage de la lumière. En effet, d'une part il peut y avoir plusieurs directions de routage de la lumière dans un même routeur optique élémentaire, comme l'illustrent la FIG.9A, la FIG.9B et la FIG.9C pour le routeur élémentaire 80 de la FIG.8A. Et d'autre part, une direction de routage de la lumière au sein d'un routeur optique élémentaire peut être une direction diagonale entre les directions X et Y suivant lesquelles des paires de routeurs optiques élémentaires peuvent être juxtaposés (*i.e.,* mis côte-à-côte) en miroir l'un de l'autre pour former un routeur optique de base symétrisé suivant l'une et/ou l'autre de ces directions X et Y. De telles directions de routage en diagonale sont représentées, par exemple, sur la FIG.9B et la FIG.9C en ce qui concerne le routage de la lumière à la longueur d'onde du rouge et du bleu, respectivement. La notion de "direction de routage" de la lumière est donc parfois trop complexe, dans certaines applications et/ou certains modes de mise en œuvre, pour systématiquement faire référence, littéralement, à une direction de routage optique de la lumière afin de définir l'agencement des routeurs optiques élémentaires qui sont combinés dans un routeur optique de base symétrisé selon l'enseignement de l'invention.

Cela étant dit, un routage suivant une direction diagonale entre les directions X et Y peut, techniquement, se décomposer en une composante suivant la direction X et une autre composante suivant la direction Y. C'est pourquoi, notamment, l'effet technique associé à la mise en miroir des routeurs optiques élémentaires suivant la direction X et/ou suivante la direction Y lorsqu'ils sont combinés dans un routeur optique de base symétrisé selon l'enseignement de l'invention, apporte toujours une atténuation de l'effet du couplage réciproque entre pixels adjacents suivants lesdites directions X et Y. L'amélioration du PER peut être de degré variable selon les modes de mise en œuvre et les applications, mais elle est toujours une réalité.

En outre, et comme la personne de métier peut l'apprécier au vu de la description, du motif élémentaire binaire 30 de la FIG.3A, du motif élémentaire quaternaire 60 de la FIG.6A ainsi que du motif élémentaire sénaire 70 de la FIG.7A, une direction de routage optique de la lumière en polarisation sera souvent la direction X ou la direction Y, dès lors qu'elle correspond à une direction suivant laquelle sont disposés côte-à-côte les deux pixels associés aux zones de sortie optique respectives d'un motif de routage binaire adapté pour trier la lumière en fonction de deux valeurs ou états de la lumière incidente seulement, dans un routeur optique élémentaire. Dans toutes ces applications, en particulier, le principe de symétrisation du motif de routage de base par mise en miroir, deux-à-deux, de couples de routeurs optiques élémentaires suivant la direction X et/ou suivant la direction Y, donne des résultats appréciables en termes d'amélioration du PER pour les pixels associés de la matrice de photodétecteurs sous-jacente.

La présente invention a été décrite et illustrée dans la présente description détaillée et dans les figures des dessins annexés, dans des formes de réalisation possibles. La présente invention ne se limite pas, toutefois, aux formes de réalisation présentées. D'autres variantes et modes de réalisation peuvent être déduits et mis en œuvre par la personne du métier à la lecture de la présente description et des dessins annexés.

Dans les revendications, le terme "comprendre" ou "comporter" n'exclut pas d'autres éléments ou d'autres étapes. Les différentes caractéristiques présentées et/ou revendiquées peuvent être avantageusement combinées. Leur présence dans la description ou dans des revendications dépendantes différentes, n'excluent pas cette possibilité. Les signes de référence indiqués entre parenthèses ne sauraient être compris comme limitant la portée de l'invention.

### Liste des documents cités

### Documents brevets

WO2023275032A1
EP4390343 A1

### Littérature non-brevet

"Metasurface-based polarization color routers", par Xiujuan Zou, Guangxing Gong, Yu Lin, Boyan Fu, Shuming Wang, Shining Zhu, et Zhenlin Wang, dans la revue Optics and Lasers in Engineering, Volume 163, Avril 2023, 107472, ISSN 0143-8166 (https://doi.org/10.1016/j.optlaseng.2022.107472).
"Efficient polarization beam splitter pixels based on a dielectric metasurface" par M. Khorasaninejad, W. Zhu, et K. B. Crozier, Optica Vol.2, Issue 4, pp. 376-382, 2015 (https://doi.org/10.1364/OPTICA.2.000376).
"Efficient polarization beam splitter pixels based on a dielectric metasurface", par Shuwen Wei, Zhenyu Yang, et Ming Zhao, Optics Letters 2017, Vol. 42, Issue 8, pp. 1580-1583, (https://doi.org/10.1364/OL.42.001580).

## Revendications

1. Détecteur optoélectronique (40), comprenant :
- une matrice (41) de photodétecteurs élémentaires ou pixels (25,26) agencés en lignes s'étendant suivant une première direction (X) et en colonnes s'étendant suivant une seconde direction (Y), différente de ladite première direction (X), lesdites première direction et seconde direction définissant le plan d'une surface du détecteur optoélectronique qui est sensible à une lumière incidente,
- un dispositif (42) de routage optique, au niveau pixel, en polarisation ou en longueur d'onde de la lumière incidente, qui est formé au-dessus de la matrice de photodétecteurs (25,26),
dans lequel:
- le dispositif (42) de routage optique de la lumière comprend un ou plusieurs routeurs de base (30x,60x,70x,70xy,80xy) présentant chacun un motif de routage de base (30x',60x',70x',70x',80xy') identique,
∘ le ou les routeurs de base étant disposés au-dessus de la matrice de photodétecteurs (25,26), le cas échéant de telle manière que le motif de routage de base est répété spatialement suivant la première direction (X) et/ou suivant la seconde direction (Y) pour couvrir tout ou partie de ladite matrice, et
∘ le motif de routage de base étant symétrique selon la première direction (X) et/ou selon la seconde direction (Y),
- chaque routeur de base comprend au moins deux routeurs élémentaires (30,60,70,80) ayant chacun une zone d'entrée optique et plusieurs zones de sortie optique,
∘ les routeurs élémentaires étant adjacents deux-à-deux suivant la première direction (X) et/ou suivant la seconde direction (Y), et
∘ les routeurs élémentaires présentant chacun un motif de routage élémentaire (30',60',70',80') identique de format N×M, où N et M sont des nombres entiers supérieurs à l'unité dont l'un au moins est strictement supérieur à l'unité, lesdits nombres N et M désignant le nombre de zones de sortie optique du routeur élémentaire qui sont adjacentes deux-à-deux, le cas échéant, suivant la première direction (X) et suivant la seconde direction (Y), respectivement,
- chaque routeur élémentaire est adapté pour trier en sortie par routage optique, c'est-à-dire par déviation sélective vers l'une des zones de sortie optique dudit routeur élémentaire, la lumière reçue au niveau de la zone d'entrée optique dudit routeur élémentaire en fonction de sa polarisation ou de sa longueur d'onde, les zones de sortie optique dudit routeur élémentaire étant couplées de manière opérationnelle chacune à un pixel associé respectif de la matrice de photodétecteurs sous-jacente qui est dédié [seul ou avec d'autres pixels similaires] à la détection d'un flux de lumière incidente avec une polarisation déterminée ou à une longueur d'onde déterminée,
- au moins deux routeurs élémentaires qui sont adjacents suivant la première direction (X) ou suivant la seconde direction (Y) au sein d'un routeur de base sont agencés de telle manière que leurs motifs de routage élémentaires (31-32, 81-84) respectifs sont disposés en miroir l'un de l'autre suivant ladite direction, de sorte qu'un ou plusieurs pixels associés à des zones de sortie de l'un desdits routeurs élémentaires et un ou plusieurs pixels associés à des zones de sortie de l'autre desdits routeurs élémentaires, qui sont dédiés à la détection du flux de lumière incidente avec un même état de polarisation ou à une même longueur d'onde, soient contigus suivant ladite direction.

2. Détecteur optoélectronique (40) selon la revendication 1, dans lequel le dispositif de routage optique de la lumière est un dispositif de routage optique en polarisation de la lumière, et dans lequel :
- un routeur élémentaire comprend un ou plusieurs routeurs binaires (30,60-1,60-2,70-1,70-2,) ayant chacun deux zones de sortie optique (31-32,61-62,63-64,71-72,73-74) respectives,
∘ les deux zones de sortie optique du routeur binaire étant adjacentes suivant la première direction (X) ou suivant la seconde direction (Y), et
∘ le routeur binaire présentant un motif de routage binaire de format 2×1 ou 1×2, respectivement,
- chaque routeur binaire est adapté pour trier en sortie par routage optique, c'est-à-dire par déviation optique sélective vers l'une des deux zones de sortie optique dudit routeur binaire, la lumière incidente reçue au niveau de la zone d'entrée optique du routeur élémentaire en fonction de sa polarisation parmi deux états de polarisation croisés respectifs.

3. Détecteur optoélectronique (40) selon la revendication 2, dans lequel :
- un routeur binaire (61-1,61-2;70-1,70-2) au moins du routeur élémentaire (60,70) est adapté pour trier en sortie par routage optique la lumière incidente reçue au niveau de la zone d'entrée optique dudit routeur élémentaire en fonction de la polarisation de ladite lumière parmi des paires d'états de polarisation linéaire orthogonaux entre eux, par exemple les polarisations linéaires à 0° et à 90°, respectivement, ou les polarisations linéaires à 45° et à 135°, respectivement.

4. Détecteur optoélectronique selon la revendication 3, dans lequel :
- le motif de routage élémentaire (60') d'un routeur élémentaire déterminé (60) est un motif de routage de format 2×2 à quatre zones de sortie optique (61,62,63,64),
∘ ledit routeur élémentaire comprenant deux routeurs binaires,
∘ lesdits routeurs binaires étant adaptés chacun pour trier en sortie par routage optique la lumière incidente reçue au niveau de la zone d'entrée optique du routeur élémentaire en fonction de la polarisation de ladite lumière parmi des paires respectives d'états de polarisation linéaire orthogonaux entre eux, à savoir par exemple les polarisations linéaires à 0° et à 90° pour l'un desdits routeurs binaires, et les polarisations linéaires à 45° et à 135° pour l'autre desdits routeurs binaires.

5. Détecteur optoélectronique selon la revendication 4, dans lequel :
- le motif de routage de base (60x') du routeur de base (60x) est un motif de routage de format 4×2 comprenant huit zones de sortie optique,
∘ ledit routeur de base comprenant deux routeurs élémentaires à motif de routage élémentaire de format 2×2 (60a,60b) comprenant chacun deux routeurs binaires à motif de routage binaire de format 2×1 ou de format 1×2, qui sont adjacents suivant la première direction (X) ou suivant la seconde direction (Y), respectivement,
∘ lesdits routeurs élémentaires étant adjacents suivant la première direction (X) ou suivant la seconde direction (Y) au sein du routeur de base et agencés de telle manière que leurs motifs de routage élémentaires (60) respectifs sont disposés en miroir l'un de l'autre suivant ladite direction, de sorte qu'un ou plusieurs pixels associés à des zones de sortie de l'un desdits routeurs élémentaires et qu'un ou plusieurs pixels associés à des zones de sortie de l'autre desdits routeurs élémentaires, qui sont dédiés à la détection du flux de lumière avec un même état de polarisation linéaire, soient contigus suivant ladite direction.

6. Détecteur optoélectronique selon la revendication 2 ou la revendication 3, dans lequel :
- un routeur binaire (70-3) au moins d'un routeur élémentaire (70) est adapté pour trier en sortie par routage optique la lumière incidente reçue au niveau de la zone d'entrée optique dudit routeur élémentaire en fonction de la polarisation de ladite lumière parmi les états de polarisation circulaire gauche et circulaire droite.

7. Détecteur optoélectronique selon la revendication 6, dans lequel :
- le motif de routage élémentaire (70') d'un routeur élémentaire (70) est un motif de routage de format 3×2 ou de format 2×3 à six zones de sortie optique (71,72,73,44,75,76),
∘ ledit routeur élémentaire comprenant trois routeurs binaires (70-1,70-2,70-3),
∘lesdits routeurs binaires étant adaptés chacun pour trier en sortie par routage optique la lumière incidente reçue au niveau de la zone d'entrée dudit routeur binaire en fonction de la polarisation de ladite lumière parmi des paires respectives d'états de polarisation orthogonaux, à savoir les états de polarisation linéaire orthogonaux à 0° et à 90° pour un premier (70-1) desdits routeurs binaires, les états de polarisation linéaire orthogonaux à 45° et à 135° pour un deuxième (70-2) desdits routeurs binaires, et les états de polarisation circulaire gauche et circulaire droite pour un troisième (70-3) desdits routeurs binaires.

8. Détecteur optoélectronique selon la revendication 7, dans lequel :
- le motif de routage de base (70x') d'un routeur de base (70x) est un motif de routage de format 4×3 ou de format 3×4 comprenant douze zones de sortie optique,
∘ ledit routeur unitaire comprenant deux routeurs élémentaires (70a,70b) à motif de routage de format 2×3 ou de format 3×2 comprenant chacun trois routeurs binaires à motif de routage de format 2×1 ou de format 1×2,
∘ lesdits routeurs élémentaires (70a,70b) étant adjacents suivant la première direction (X) ou suivant la seconde direction (Y) au sein du routeur de base (70x) et agencés de telle manière que leurs motifs de routage élémentaires (70) respectifs sont disposés en miroir l'un de l'autre suivant ladite direction, de sorte qu'un ou plusieurs pixels associés à des zones de sortie optique de l'un desdits routeurs élémentaires et qu'un ou plusieurs pixels associés à des zones de sortie optique de l'autre desdits routeurs élémentaires, qui sont dédiés à la détection du flux de lumière incident avec un même état de polarisation, soient contigus suivant ladite direction.

9. Détecteur optoélectronique selon la revendication 6, dans lequel :
- le motif de routage de base (70xy') d'un routeur de base (70xy) est un motif de routage de format 4×6 comprenant vingt-quatre zones de sortie optique,
∘ ledit routeur de base comprenant quatre routeurs élémentaires à motif de routage de format 2×3 ou de format 3×2 (70a,70b,70c,70d) comprenant chacun trois routeurs binaires à motif de routage élémentaire de format 2×1 ou de format 1×2,
∘ lesdits routeurs élémentaires (70a,70b,70c,70d) étant adjacents deux-à-deux suivant la première direction (X) et suivant la seconde direction (Y) au sein du routeur de base (70xy) et étant agencés de telle manière que leurs motifs de routage élémentaires (70) respectifs sont disposés deux-à-deux en miroir les uns des autres suivant ladite première direction (X) et suivant ladite seconde direction (Y), de sorte qu'un ou plusieurs pixels associés à des zones de sortie optique de l'un desdits routeurs élémentaires et qu'un ou plusieurs pixels associés à des zones de sortie optique de l'autre desdits routeurs élémentaires, qui sont dédiés à la détection du flux de lumière incident avec un même état de polarisation, soient contigus suivant ladite direction.

10. Détecteur optoélectronique selon la revendication 1, dans lequel le dispositif de routage optique de la lumière est un dispositif de routage en longueur d'onde de la lumière, et dans lequel :
- le motif de routage élémentaire (80') d'un routeur élémentaire (80) est un motif de routage comprenant au moins deux zones de sortie optique (81,82,83,84) qui sont associées chacune à une longueur d'onde déterminée, par exemple une longueur d'onde parmi les longueurs d'onde correspondant aux couleurs rouge, vert et bleu, respectivement.

11. Détecteur optoélectronique selon la revendication 10, dans lequel :
- le motif de routage élémentaire (80') d'un routeur élémentaire (80) est un motif de routage de format 2×2 comprenant quatre zones de sortie optique (81,82,83,84), dont :
∘une zone de sortie optique est couplée de manière opérationnelle à un pixel de la matrice de photodétecteurs sous-jacente qui est dédié à la détection de la lumière à la longueur d'onde correspondant à la couleur rouge, et
∘ deux autres zones de sortie optique qui sont mutuellement opposées diamétralement, et sont respectivement couplées de manière opérationnelle à deux pixels de la matrice de photodétecteurs sous-jacente qui sont dédiés à la détection de la lumière à la longueur d'onde correspondant à la couleur vert,
∘l'autre zone de sortie optique encore est couplée de manière opérationnelle à un pixel de la matrice de photodétecteurs sous-jacente qui est dédié à la détection de la lumière à la longueur d'onde correspondant à la couleur bleu.

12. Détecteur optoélectronique selon la revendication 8, dans lequel :
- le motif de routage de base (80xy') d'un routeur de base (80xy) est un motif de routage de format 4×4 comprenant seize zones de sortie optique,
∘ ledit routeur de base comprenant quatre routeurs élémentaires chacun à motif de routage de format 2×2 (80a,80b,80c,80d) qui sont adjacents deux-à-deux suivant la première direction (X) et suivant la seconde direction (Y) au sein du routeur de base (80xy) et agencés de telle manière que leurs motifs de routage élémentaires (80) respectifs sont disposés deux-à-deux en miroir les uns des autres suivant ladite première direction (X) et suivant ladite seconde direction (Y).

13. Détecteur optoélectronique selon l'une quelconque des revendications 1 à 12, dans lequel le dispositif de routage optique (42) en polarisation ou en longueur d'onde de la lumière est formé d'une méta-structure de routage optique adaptée pour trier en sortie des routeurs élémentaires par routage optique, c'est-à-dire pour dévier sélectivement vers l'une ou l'autre des zones de sortie optique desdits routeurs élémentaires, la lumière incidente reçue en entrée de la méta-structure en fonction de son état de polarisation ou de sa longueur d'onde.

14. Détecteur optoélectronique selon l'une quelconque des revendications 1 à 13, dans lequel des routeurs de base (30x,60x,70x,70xy,80xy) répétés dans le dispositif de routage optique sont formés côte-à-côte et sans espacement, suivant la première direction (X) ou suivant la seconde direction (Y).

15. Capteur d'image en technologie CMOS comprenant un détecteur optoélectronique selon l'une quelconque des revendications 1 à 14.
